# EUROPEAN PATENT SPECIFICATION

(11) **EP 4 485 515 B1**
(45) Date of publication and mention of the grant of the patent: **10.06.2026**
(21) Application number: 22937835.1
(22) Date of filing: 20.04.2022
(51) Int. Cl.: H01L 21/768, H01L 23/532

(54) **CHIP, PREPARATION METHOD THEREFOR AND ELECTRONIC DEVICE**
CHIP, HERSTELLUNGSVERFAHREN DAFÜR UND ELEKTRONISCHE VORRICHTUNG
PUCE, SON PROCÉDÉ DE PRÉPARATION, ET DISPOSITIF ÉLECTRONIQUE

(43) Date of publication of application: 01.01.2025
(73) Proprietor: Huawei Technologies Co., Ltd., Shenzhen, Guangdong 518129 (CN)
(72) Inventor: HUANG, Weichuan, Shenzhen, Guangdong 518129 (CN); CHEN, Dongqi, Shenzhen, Guangdong 518129 (CN); XIE, Yusi, Shenzhen, Guangdong 518129 (CN); LIN, Jun, Shenzhen, Guangdong 518129 (CN)
(74) Representative: Gill Jennings & Every LLP
(86) International application number: PCT/CN2022/088028
(87) International publication number: WO 2023/201598

(56) References cited:
- WO-A1-2021/184166
- CN-A- 101 197 311
- CN-A- 101 197 311
- CN-A- 111 755 409
- US-A1- 2019 164 781

## Description

### TECHNICAL FIELD

This application relates to the field of semiconductor technologies, and in particular, to a chip and a preparation method thereof, and an electronic device.

### BACKGROUND

With development of electronic technologies, users pose increasingly high requirements on performance of electronic devices, causing an increasingly large chip size and an increasingly large quantity of chips in the electronic device. However, as the electronic device continues to evolve toward integration and ultra-thinness, the chip in the electronic device needs to be miniaturized. Based on this, to meet both a performance requirement and a size requirement of the electronic device on the chip, a size of a conductive pattern in the chip needs to be reduced.

However, reduction in the size of the conductive pattern increases difficulty in interconnection and coupling between conductive patterns. In addition, when the conductive patterns are interconnected and coupled through a conductive pillar, resistance and a preparation process and other characteristics of the conductive pillar directly affect interconnection and coupling effect and a chip yield rate.

Document CN101197311A discloses a metallic connection structure manufacturing method that involves depositing medium layer on underlay surface of semiconductor, and forming metallic connection structure in medium layer by dual damascene technique.

### SUMMARY

Embodiments of this application provide a chip and a preparation method thereof, and an electronic device, to improve interconnection and coupling effect between conductive patterns in a chip.

To achieve the foregoing objective, this application uses the following technical solutions.

According to a first aspect of embodiments of this application, a chip is provided. The chip may be a die, or may be a packaged chip. The chip includes: a first conductive pillar and a dielectric layer, where the first conductive pillar is disposed in the dielectric layer, and runs through the dielectric layer in a thickness direction of the dielectric layer, or it may be understood that the dielectric layer wraps a periphery of the first conductive pillar; and a first conductive pattern and a second conductive pattern, located on two opposite sides of the first conductive pillar, where the first conductive pillar is correspondingly coupled to the first conductive pattern and the second conductive pattern, the first conductive pillar includes a metal pillar and a metal compound layer, the metal compound layer is located between the metal pillar and the dielectric layer and covers at least a part of a side surface of the metal pillar, the first conductive pillar is in contact with the dielectric layer through the metal compound layer and a side surface that is of the metal pillar and that is not covered by the metal compound layer, and no film layer such as a barrier layer is disposed between the first conductive pillar and the dielectric layer. It should be understood that, if the entire side surface of the metal pillar is completely covered by the metal compound layer, a part that is of the metal pillar and that is not covered by the metal compound layer does not exist, and the first conductive pillar is in contact with the dielectric layer through the metal compound layer. In addition, structures of the first conductive pattern and the second conductive pattern are different based on different chip structures.

In the chip provided in this embodiment of this application, the first conductive pattern and the second conductive pattern are coupled through the first conductive pillar, and the first conductive pillar is directly in contact with the dielectric layer without the film layer such as the barrier layer. In this way, no film layer such as the barrier layer occupies space, and a depth-to-width ratio of the first conductive pillar can be increased. In addition, the resistance of the first conductive pillar is not affected by the film layer such as the barrier layer, and the resistance of the first conductive pillar can be effectively reduced. On this basis, the first conductive pillar includes the metal pillar and the metal compound layer. A gap defect existing between the formed metal pillar and the dielectric layer due to a process limitation can be filled by using the metal compound layer. This can avoid as far as possible damage to the first conductive pattern at the bottom of the first conductive pillar and eventual failure of the chip that are caused by penetration of a solution, for example, an acid lapping liquid, a cleaning fluid, or an etchant, into a gap between the first conductive pillar and the dielectric layer. In addition, because the gap between the metal pillar and the dielectric layer is very small, a volume of the metal compound layer located in the gap is also very small. Therefore, impact of the metal compound layer on the resistance of the first conductive pillar is very small and can be almost ignored, and existence of the metal compound layer does not cause an increase in the resistance of the first conductive pillar.

In a possible implementation, the metal pillar is formed by using a selective deposition process. The metal pillar is formed by using the selective deposition process, and no film layer such as the barrier layer is needed. This can increase a width-to-length ratio of the metal pillar. In addition, no void is formed inside the formed metal pillar, and the resistance of the first conductive pillar can be reduced.

In a possible implementation, the metal compound layer includes a metal oxide material. In this implementation, the process is simple.

In a possible implementation, the metal compound layer includes a metal nitride material. In this implementation, the process is simple.

In a possible implementation, the metal compound layer includes a metal oxide material and a metal nitride material. In this implementation, the process is simple.

In a possible implementation, the metal compound layer includes a metal oxynitride material. In this implementation, the process is simple.

In a possible implementation, the metal compound layer includes a metal oxide material and a metal oxynitride material. In this implementation, the process is simple.

In a possible implementation, the metal compound layer includes a metal nitride material and a metal oxynitride material. In this implementation, the process is simple.

In a possible implementation, the metal compound layer includes a metal oxide material, a metal nitride material, and a metal oxynitride material. In this implementation, the process is simple.

In a possible implementation, the metal compound layer is obtained by performing oxidation treatment on the side surface of the metal pillar. In this implementation, the process is simple.

In a possible implementation, the metal compound layer is obtained by performing nitride treatment on the side surface of the metal pillar. In this implementation, the process is simple.

In a possible implementation, the metal compound layer is obtained by performing oxidation treatment and nitride treatment on the side surface of the metal pillar. In this implementation, the process is simple.

In a possible implementation, a metal included in the metal compound layer is the same as a metal included in the metal compound layer.

In a possible implementation, a surface that is of the metal compound layer and that faces the metal pillar is flat. The metal compound layer is formed by using a process-controllable processing manner, thereby improving controllability of the chip structure.

In a possible implementation, the metal compound layer has a width of 0.5 nm to 5 nm in a direction parallel to the dielectric layer. A width of a metal oxide layer is controlled to be less than 5 nm, so that the gap between the first conductive pillar and the dielectric layer can be filled, and impact of the metal oxide layer on the resistance of the first conductive pillar is very small, and can be almost ignored. Therefore, a problem that the resistance of the first conductive pillar increases due to existence of the metal oxide layer is improved.

In a possible implementation, a material of the first conductive pattern includes metal, and the first conductive pillar is in contact with the first conductive pattern. The metal pillar is formed by using the selective deposition process on the metal structure, and the process is simple and easy to implement.

In a possible implementation, the chip includes an electronic component and a first redistribution layer, the first conductive pattern is disposed between the first conductive pillar and the electronic component, and the first redistribution layer includes the second conductive pattern. This is an application scenario.

In a possible implementation, the chip includes a first integrated circuit module, a second redistribution layer, a second integrated circuit module, and a third redistribution layer that are sequentially stacked; and the second redistribution layer includes the first conductive pattern, the first conductive pattern is coupled to the first integrated circuit module, the first conductive pillar runs through the second integrated circuit module, the third redistribution layer includes the second conductive pattern, and the third redistribution layer is further coupled to the second integrated circuit module. This is an application scenario.

In a possible implementation, the chip includes a die; a solder pad of the die is the first conductive pattern, and the first conductive pillar runs through a non-active surface of the die to a rear surface of the solder pad; and the chip further includes a fourth redistribution layer, and the fourth redistribution layer includes the second conductive pattern. This is an application scenario.

In a possible implementation, the chip includes a die; a solder pad of the die is the first conductive pattern, and the first conductive pillar runs through a non-active surface of the die to a rear surface of the solder pad; and the second conductive pattern is a solder joint located on the non-active surface of the die. This is an application scenario.

In a possible implementation, the chip includes a plurality of first conductive pillars, and oxygen content, nitrogen content, or widths of a plurality of metal compound layers included in the plurality of first conductive pillars are not completely the same.

In a possible implementation, the chip further includes a second conductive pillar, the second conductive pillar is the metal pillar, the metal pillar is disposed in the dielectric layer and runs through the dielectric layer in the thickness direction of the dielectric layer, and a side surface of the metal pillar is in contact with the dielectric layer.

According to a second aspect of embodiments of this application, an electronic device is provided, including the chip according to any implementation of the first aspect and a circuit board, where the chip is disposed on the circuit board.

The electronic device provided in this embodiment of this application includes the chip according to any implementation of the first aspect, and beneficial effect of the electronic device is the same as beneficial effect of the chip. Details are not described herein again.

According to a third aspect of embodiments of this application, a chip preparation method is provided, including: providing a dielectric layer and a first conductive pattern located on a first intermediate dielectric layer side, where the dielectric layer has a hole, and the hole is located above the first conductive pattern; by using a selective deposition process, depositing from a surface of the first conductive pattern in the hole, to form a metal pillar body from bottom to top; performing chemical processing on the metal pillar body, so that a side surface that is of the metal pillar body and that is not in contact with the dielectric layer expands to be in contact with the dielectric layer; removing a chemically processed part of a top surface of the metal pillar body to form a first conductive pillar, where the first conductive pillar includes a metal pillar and a metal compound layer, a part that is of the metal pillar body and that is not chemically processed is the metal pillar, a chemically processed part of the side surface of the metal pillar body is the metal compound layer, the metal compound layer is in contact with the dielectric layer, and a side surface that is of the metal pillar and that is not covered by the metal compound layer is also in contact with the dielectric layer; and forming a second conductive pattern on a side that is of the dielectric layer and that is away from the first conductive pattern, where the second conductive pattern is coupled to the first conductive pillar.

Beneficial effect of the chip preparation method provided in this embodiment of this application is the same as beneficial effect of the chip. Details are not described herein again.

In a possible implementation, the performing chemical processing on the metal pillar body includes: performing oxidation treatment on the metal pillar body. In this implementation, the process is simple.

In a possible implementation, the performing chemical processing on the metal pillar body includes: performing nitride treatment on the metal pillar body. In this implementation, the process is simple.

### BRIEF DESCRIPTION OF DRAWINGS

FIG. 1 is a diagram of a framework of an electronic device according to an embodiment of this application;
FIG. 2A to FIG. 2D are a diagram of a die preparation process according to an embodiment of this application;
FIG. 3A is a diagram of a structure of a conductive pillar in a chip according to an embodiment of this application;
FIG. 3B is a diagram of a structure of another conductive pillar in a chip according to an embodiment of this application;
FIG. 4 is a flowchart of a chip preparation method according to an embodiment of this application;
FIG. 5A to FIG. 9C are a diagram of a chip preparation process according to an embodiment of this application;
FIG. 10A is a diagram of a structure of another chip according to an embodiment of this application;
FIG. 10B is a diagram of a macrostructure of a chip according to an embodiment of this application;
FIG. 11A to FIG. 11D are a diagram of another chip preparation process according to an embodiment of this application;
FIG. 12A is a diagram of a structure of still another chip according to an embodiment of this application;
FIG. 12B is a diagram of a structure of a die according to an embodiment of this application;
FIG. 12C to FIG. 12F are a diagram of still another chip preparation process according to an embodiment of this application; and
FIG. 13 is a diagram of a structure of still another chip according to an embodiment of this application.

### Reference numerals:

1: electronic device; 2: display module; 3: middle frame; 4: housing; 5: cover; 100: substrate; 10: dielectric layer; 101: first dielectric layer; 102: second dielectric layer; 11: hole; 20: electronic component; 21: first conductive pattern; 30: metal pillar body; 31: first conductive pillar; 311: metal pillar; 312: metal compound layer; 32: second conductive pillar; 40: first redistribution layer; 41: second conductive pattern; 50: first integrated circuit module; 60: second redistribution layer; 70: second integrated circuit module; 80: third redistribution layer; 91: first die; 92: second die; and 99: fourth redistribution layer.

### DESCRIPTION OF EMBODIMENTS

The following describes technical solutions in embodiments of this application with reference to accompanying drawings in embodiments of this application. It is clear that the described embodiments are merely a part rather than all of embodiments of this application.

Terms such as "first" and "second" mentioned below in embodiments of this application are merely used for ease of description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two.

In addition, in embodiments of this application, "up", "down", "left", and "right" are not limited to definitions relative to directions in which parts are schematically placed in the accompanying drawings. It should be understood that these directional terms may be relative concepts used for relative description and clarification, and may change correspondingly based on a change of a direction in which a part in an accompanying drawing is placed.

In embodiments of this application, unless otherwise specified in the context, in the entire specification and claims, the term "include" is interpreted as "open and inclusive", that is, "include, but not limited to". In the descriptions of the specification, terms such as "an embodiment", "some embodiments", "example embodiments", "examples", or "some examples" are intended to indicate that specific features, structures, materials, or features related to embodiments or examples are included in at least one embodiment or example of the present disclosure. The foregoing schematic representations of the terms do not necessarily refer to a same embodiment or example. Further, the particular feature, structure, material, or characteristic may be included in any one or more embodiments or examples in any appropriate manner.

When some embodiments are described, expressions of "coupling" and its extensions may be used. For example, when some embodiments are described, the term "coupling" may be used to indicate that two or more components are in direct physical contact or electrical contact. However, the term "coupling" may also indicate that two or more components do not directly contact each other, but still collaborate or interact with each other. Embodiments disclosed herein are not necessarily limited to content of this specification.

The term "and/or" in embodiments of this application describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

In embodiments of this application, an example implementation is described with reference to a sectional view and/or a plane diagram and/or an equivalent circuit diagram that are/is used as an idealized example accompanying drawing. In the accompanying drawings, for clarity, thicknesses of layers and regions are increased. Thus, a change in a shape in the accompanying drawings due to, for example, manufacturing techniques and/or tolerances may be envisaged. Therefore, example implementations should not be construed as being limited to a shape of a region shown herein, but rather include shape deviations due to, for example, manufacturing. For example, an etching region shown as a rectangle typically has a bending characteristic. Therefore, the regions shown in the accompanying drawings are essentially examples, and their shapes are not intended to show actual shapes of regions of a device, and are not intended to limit a scope of the example implementations.

An embodiment of this application provides an electronic device. The electronic device is, for example, a consumer electronic product, a home electronic product, a vehicle-mounted electronic product, a financial terminal product, or a communication electronic product. The consumer electronic product is, for example, a mobile phone (mobile phone), a tablet computer (solder pad), a notebook computer, an e-reader, a personal computer (personal computer, PC), a personal digital assistant (personal digital assistant, PDA), a desktop display, a smart wearable product (for example, a smartwatch or a smart band), a virtual reality (virtual reality, VR) terminal device, an augmented reality (augmented reality, AR) terminal device, or an uncrewed aerial vehicle. The home electronic product is, for example, an intelligent lock, a television, a remote control, a refrigerator, and a small household charging appliance (such as a soy milk maker and a robot vacuum). The vehicle-mounted electronic product is, for example, a vehicle-mounted navigator, or a vehicle-mounted high-density digital video disc (digital video disc, DVD). The financial terminal product is, for example, an automated teller machine (automated teller machine, ATM), or a terminal for self-service business handling. For example, the communication electronic product is a communication device like a server, a memory, or a base station.

A specific form of the electronic device is not specifically limited in this embodiment of this application. For ease of description, an example in which the electronic device is a mobile phone is used for description in the following embodiments.

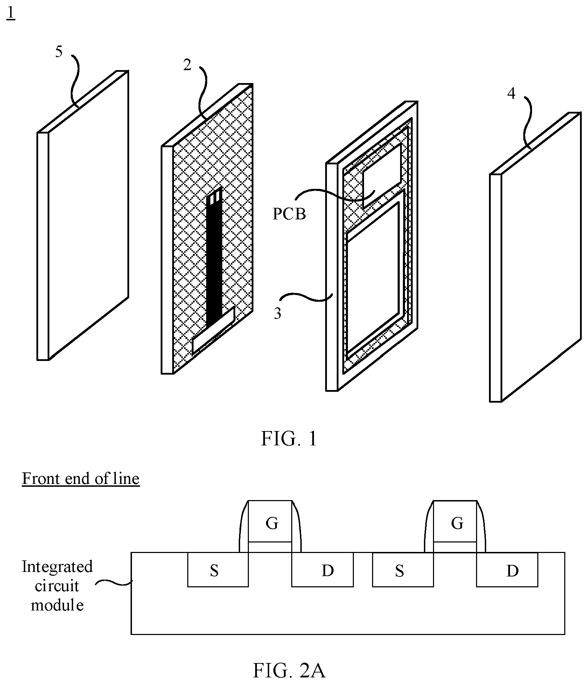

In this case, as shown in FIG. 1, an electronic device 1 mainly includes a display module 2, a middle frame 3, a housing (or referred to as a battery cover or a rear housing) 4, and a cover 5.

The display module 2 has a light emitting side capable of showing a displayed image and a rear surface opposite to the light emitting side. The rear surface of the display module 2 is close to the middle frame 3, and the cover 5 is disposed on the light emitting side of the display module 2.

The display module 2 includes a display panel (display panel, DP).

In a possible embodiment of this application, the display module 2 is a liquid crystal display module. In this case, the display panel is a liquid crystal display (liquid crystal display, LCD). Based on this, the display module 2 further includes a backlight unit (back light unit, BLU) located on a rear surface of the liquid crystal display (away from a side surface that is of the LCD and that is used to display an image).

The backlight unit may provide a light source for the liquid crystal display, so that each sub pixel (sub pixel) in the liquid crystal display can emit light to display the image.

Alternatively, in another possible embodiment of this application, the display module 2 is an organic light emitting diode display module. In this case, the display panel is an organic light emitting diode (organic light emitting diode, OLED) display. Because an electroluminescence layer is disposed in each sub pixel in the OLED display, the OLED display may implement self-luminescence after receiving an operating voltage. In this case, the backlight unit does not need to be disposed in the display module 2 having the OLED display.

The cover 5 is located on a side that is of the display module 2 and that is away from the middle frame 3. The cover 5, for example, may be cover glass (cover glass, CG), and the cover glass may have specific toughness.

The middle frame 3 is located between the display module 2 and the housing 4. A surface that is of the middle frame 3 and that is away from the display module 2 is used to install internal components such as a battery, a printed circuit board (printed circuit board, PCB), a camera (camera), and an antenna. After the housing 4 covers the middle frame 3, the internal components are located between the housing 4 and the middle frame 3.

The electronic device 1 further includes a central processing unit (central processing unit, CPU) chip, a radio frequency chip, a radio frequency power amplifier (power amplifier, PA) chip, a system on a chip (system on a chip, SOC), a power management integrated circuit (power management integrated circuits, PMIC), a storage chip (for example, a high bandwidth memory (high bandwidth memory, HBM)), an audio processor chip, a touchscreen control chip, a NAND flash (a flash memory), an image sensor chip, a charging protection chip, and the like that are disposed on the PCB. The PCB is configured to carry the foregoing chips, and completes signal interaction with the foregoing chips.

Performance such as reliability of the chip (or referred to as a logic integrated device, or referred to as an integrated circuit device) directly affects a service life and performance of the electronic device.

An embodiment of this application provides a chip, and the chip may be applied to the foregoing electronic device.

The chip provided in this embodiment of this application may be an unpackaged die. The unpackaged die may include an integrated circuit module (which may be referred to as a two-dimensional (2D) die), or the unpackaged die may include a plurality of integrated circuit modules (which may be referred to as a three-dimensional (3D) die). The chip provided in this embodiment of this application may alternatively be a packaged chip, and the packaged chip may include one die, or may include a plurality of dies.

The following uses several examples to describe the chip provided in embodiments of this application.

### Example 1

An embodiment of this application provides a chip, and the chip is a 2D die.

A chip preparation process usually includes a front end of line (front end of line, FEOL), a mid end of line (mid end of line, MEOL), and a back end of line (back end of line, BEOL).

As shown in FIG. 2A, the front end of line is used to form an integrated circuit module including electronic components such as a transistor, a capacitor, and an inductor. The electronic component in this embodiment of this application may be a component that is prepared on a substrate by using a front-end process and that is not independently packaged. Certainly, based on different preparation processes, the integrated circuit module including the electronic components such as the transistor, the capacitor, and the inductor may alternatively be prepared in the back end of line. This is merely an example in this embodiment of this application. In FIG. 2A, two transistors in the integrated circuit module are used as an example for illustration. The transistor includes a source S, a drain D, and a gate G.

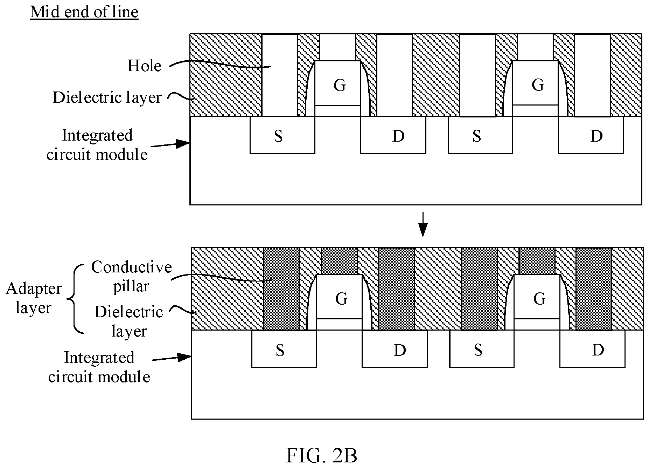

As shown in FIG. 2B, the mid end of line is used to form an contact layer that leads conductive patterns in a plurality of electronic components to a same plane. A conductive pillar in the contact layer is coupled to the source S, the drain D, and the gate G of the electronic component. For forming of the adapter layer, a dielectric layer with a hole is usually formed first, where the hole in the dielectric layer is located above the conductive pattern, and then the conductive pillar is formed by using a hole filling technology.

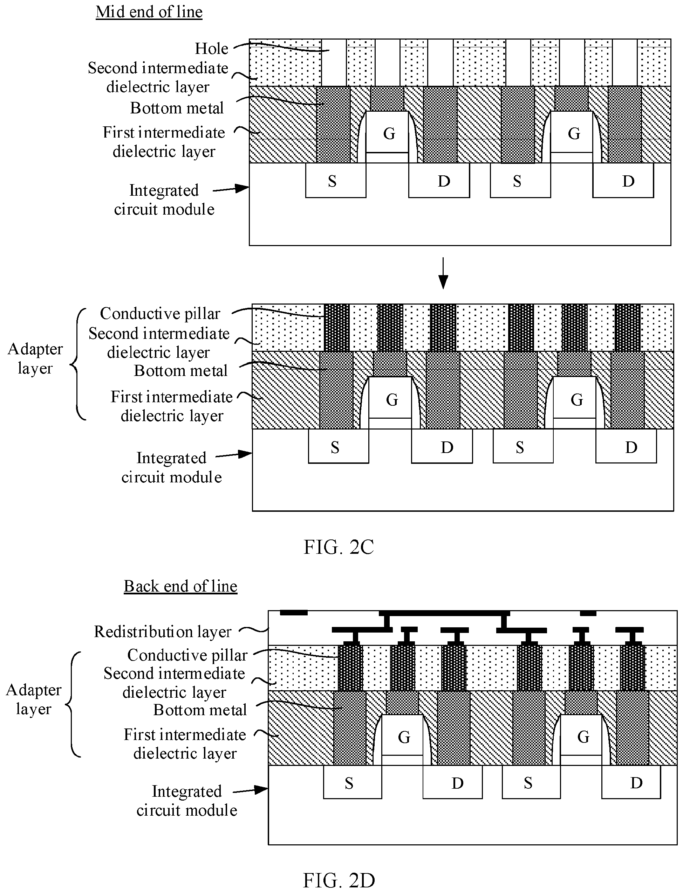

As shown in FIG. 2C, in some process nodes, the contact layer formed in the mid end of line includes two parts. The first part is bottom metal disposed on a surface of the integrated circuit and a first intermediate dielectric layer wrapped around a periphery of the bottom metal. The bottom metal is coupled to the source S, the drain D, and the gate G of the electronic component. The second part is the conductive pillar disposed on a surface of the bottom metal and a second intermediate dielectric layer wrapped around a periphery of the conductive pillar, where the conductive pillar is coupled to the bottom metal. The bottom metal is, for example, a strip shape, and the conductive pillar is, for example, a columnar shape. This structure in FIG. 2C can optimize redistribution layer arrangement in the back end of line.

For ease of description, the following uses an example in which a structure formed in the mid end of line is the structure shown in FIG. 2C for illustration.

As shown in FIG. 2D, the back end of line is used to form a redistribution layer located on the adapter layer. A signal in the electronic component is transmitted to the redistribution layer through the adapter layer, and is led out to a signal end on a surface of the redistribution layer. After the chip is formed, the signal end is exposed to a surface of the chip. For example, the signal end is used as a solder pad of the chip.

With continuous forward development of integrated circuit technologies, chips are further integrated and miniaturized, and feature sizes of electronic components such as transistors are also reduced accordingly, which poses a new challenge to the hole filling technology for interconnecting the electronic component to metal of the redistribution layer through the conductive pillar in the mid end of line.

In some embodiments, a copper (Cu) pillar formed by using an electroplating process is the conductive pillar.

In some other embodiments, a tungsten (W) pillar formed by chemical vapor deposition (chemical vapor deposition, CVD) is the conductive pillar.

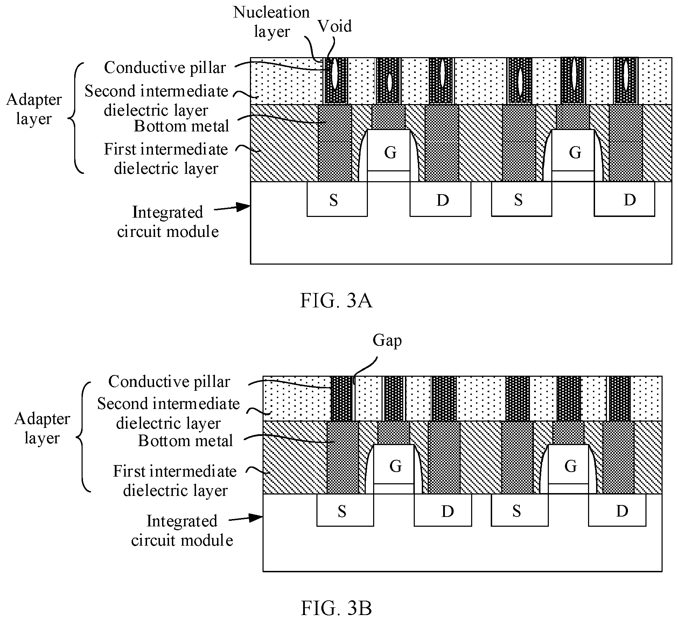

However, using the electroplating process usually needs a barrier layer (or an adhesion layer) and an electroplating seed layer, and the barrier layer covers a side surface and a bottom surface of the conductive pillar. Using the chemical vapor deposition process usually needs a nucleation layer, and the nucleation layer covers a side surface and a bottom surface of the conductive pillar. However, the barrier layer, the seed layer, or the nucleation layer occupies void space of the hole in the second intermediate dielectric layer. As a result, a hole diameter is reduced, a depth-to-width ratio of the hole is increased, and a process difficulty of the conductive pillar is increased. In addition, in the process of forming the conductive pillar by using the electroplating process, a metal pillar is electroplated from the bottom and the side surface of the hole at the same time, and an electroplating rate at the corner is higher. Therefore, a case in which the surface of the conductive pillar is sealed but void exists inside the conductive pillar easily occurs (as shown in FIG. 3A). Similarly, in the process of forming the conductive pillar by using the chemical vapor deposition process, the metal pillar is deposited from the bottom and the side surface of the hole at the same time, and a deposit rate at the corner is higher. Therefore, a case in which the surface of the conductive pillar is sealed but void exists inside the conductive pillar easily occurs. However, the void inside the conductive pillar causes high resistance of the conductive pillar, which cannot meet performance for chip miniaturization.

Based on this, in some embodiments, thin titanium nitride (TiN) is used as the barrier layer, and cobalt (Co) for hole filling is used as the conductive pillar. In this way, a process window of the conductive pillar can be increased, and the resistance of the conductive pillar can be reduced.

However, as the process node is further miniaturized, this cobalt-filled structure that needs the barrier layer still cannot meet a requirement of a high-performance chip.

Based on this, in some embodiments, the conductive pillar is formed by a selective depositing tungsten (W) by using chemical vapor deposition process.

In the selective deposition process, metal is deposited from bottom to top from the surface of the bottom metal exposed at the bottom of the hole, instead of being deposited on a hole wall of the hole in the second intermediate dielectric layer, and no barrier layer is needed. In this way, no barrier layer occupies the void space, and the conductive pillar is directly formed in the hole. This is applied to a chip structure with a large depth-to-width ratio. In addition, because the metal tungsten is deposited from bottom to top, no void exists inside the formed conductive pillar, and the resistance of the conductive pillar can be reduced.

However, because the metal tungsten is not deposited on the hole wall of the hole in the second intermediate dielectric layer, no barrier layer exists between the conductive pillar formed through deposition by using the selective deposition process and a dielectric of the hole wall in the second intermediate dielectric layer. Consequently, a random and irregular gap defect is easily formed between the conductive pillar and the second intermediate dielectric layer (as shown in FIG. 3B). In this case, in a subsequent process such as chemical mechanical polishing (chemical mechanical polishing, CMP) after hole filling or subsequent film layer patterning by using an etching process, a solution such as an acid lapping liquid or an etchant is easily penetrated into the gap between the conductive pillar and the second intermediate dielectric layer, resulting in damage to the bottom metal at the bottom of the conductive pillar and eventual failure of the chip.

Based on this, an embodiment of this application further provides a conductive pillar and a conductive pillar forming method. The conductive pillar formed by using the method provided in this embodiment of this application is directly in close contact with the second intermediate dielectric layer, and no residual gap exists.

The following describes a structure of the conductive pillar and a preparation method with reference to a chip structure.

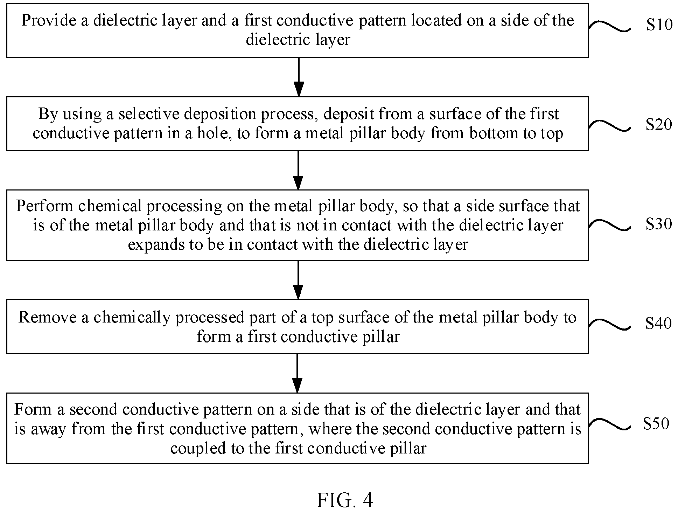

As shown in FIG. 4, a chip preparation method is provided. Steps are as follows.

S10: Provide a dielectric layer and a first conductive pattern located on a first intermediate dielectric layer side.

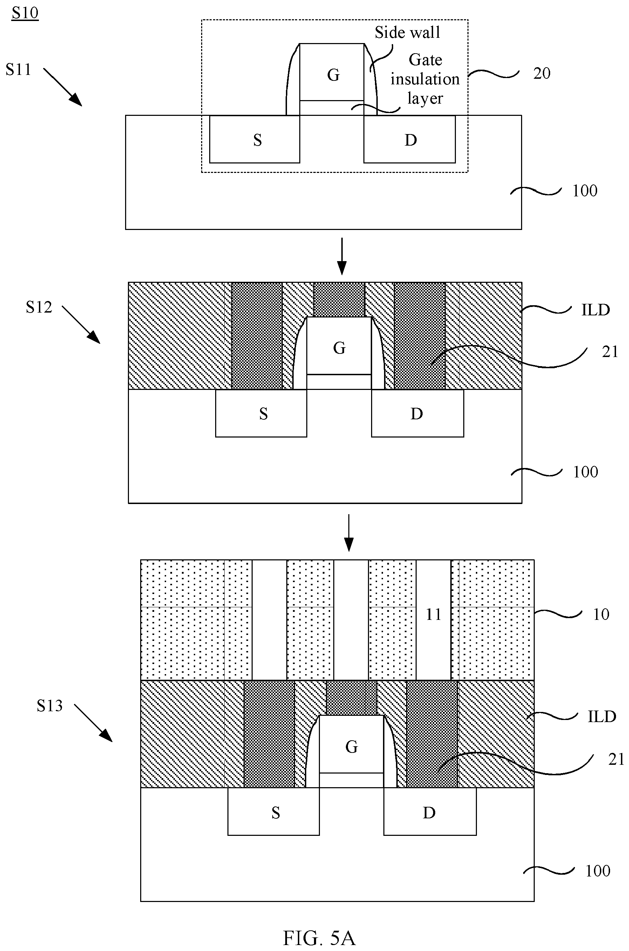

In some embodiments, as shown in FIG. 5A, step S10 includes:

S11: Form an electronic component 20 on a substrate 100 to form an integrated circuit module of a chip.

When the chip is applied to an electronic device such as a base station as a radio frequency device, a material of the substrate 100 is an insulation material. When the chip is applied to an electronic device such as a mobile phone as a power device, a material of the substrate 100 is a conductive material.

The electronic component 20 is a basic element in an electronic circuit, and has at least one lead wire contact. The lead wire contact is configured to be interconnected and coupled to a wiring to complete signal transmission. The electronic component 20 may be a resistor, a capacitor, an inductor, a transistor, a diode, an operational amplifier, a resistor array, a logic gate, or the like. For example, the electronic component 20 is a transistor, and lead wire contacts included in the electronic component 20 are a source S, a drain D, and a gate G.

The chip may include one electronic component 20, or may include a plurality of electronic components 20. In the chip preparation method provided in this embodiment of this application, one electronic component 20 in the chip is used only as an example to describe a structure of each part in the chip. When the chip includes the plurality of electronic components 20, the plurality of electronic components 20 may be a same type of electronic components, or may be different types of electronic components. A quantity, a type, and an arrangement manner of the electronic components 20 in the chip are not limited in this embodiment of this application, and may be properly disposed as needed. Each electronic component 20 includes at least one first conductive pattern 21.

For example, as shown in FIG. 5A, the electronic component 20 includes a complementary metal oxide semiconductor (complementary metal oxide semiconductor, CMOS) device, and a source S, a drain D, and a gate G of the CMOS are all lead wire contacts of the electronic component 20. FIG. 5A further shows a gate insulation layer located below the gate G and a side wall located on a side surface of the gate G. The structure of the electronic component 20 shown in FIG. 5A is merely an example, and is not limited.

Alternatively, for example, the electronic component 20 is a high electron mobility transistor (high electron mobility transistor, HEMT), a heterojunction bipolar transistor (heterojunction bipolar transistor, HBT), a bipolar junction transistor (bipolar junction transistor, BJT), or the like.

S12: Form, on a surface of the electronic component 20, a bottom metal (the first conductive pattern 21) and an inter level dielectric (inter level dielectric, ILD) layer that wraps a periphery of the bottom metal.

A shape of the top view of the bottom metal is not limited, for example, may be a strip shape. The bottom metal may be used as the first conductive pattern 21 in this example. Certainly, another metal pattern on the bottom metal may alternatively be used as the first conductive pattern 21 in this example. This is merely an example. There may be one or more first conductive patterns 21 included in the chip.

S13: Form a dielectric layer 10 on the inter level dielectric ILD layer, where the dielectric layer 10 has a hole 11, and the hole 11 is located above the first conductive pattern 21 and is in contact with the first conductive pattern 21.

A shape and a size of the hole 11 are not limited in this embodiment of this application. The hole 11 may expose a partial region of a top surface that is of the first conductive pattern 21 and that is away from the substrate 100, or the hole 11 may alternatively expose an entire region of a top surface that is of the first conductive pattern 21 and that is away from the substrate 100. Alternatively, it is understood that a projection of the hole 11 on the substrate 100 may be located in a projection of the first conductive pattern 21 on the substrate 100, or a projection of the hole 11 on the substrate 100 may alternatively overlap a projection of the first conductive pattern 21 on the substrate 100. Certainly, the projection of the hole 11 on the substrate 100 may alternatively cover the projection of the first conductive pattern 21 on the substrate 100, provided that it is ensured that a first conductive pillar subsequently formed in the hole 11 does not cause a short circuit of the adjacent first conductive pattern 21. Alternatively, it is understood that the hole 11 is located above the first conductive pattern 21, an area of the hole 11 may be less than an area of the first conductive pattern 21, an area of the hole 11 may be equal to an area of the first conductive pattern 21, or an area of the hole 11 may be greater than an area of the first conductive pattern 21. In this embodiment of this application, an example in which an area of the hole 11 is less than an area of the top surface of the first conductive pattern 21 is used for description.

A quantity of holes 11 is not limited in this embodiment of this application, and the quantity of holes 11 is correspondingly disposed with a quantity of first conductive patterns 21. It should be emphasized that one first conductive pattern 21 may be correspondingly disposed with one hole 11, in other words, only one hole 11 may be disposed above one first conductive pattern 21. One first conductive pattern 21 may alternatively be correspondingly disposed with a plurality of holes 11, in other words, the plurality of holes 11 may be disposed above one first conductive pattern 21. Alternatively, a plurality of first conductive patterns 21 may be correspondingly disposed with one hole 11, that is, the hole 11 is correspondingly disposed above the plurality of first conductive patterns 21 (for example, the plurality of first conductive patterns 21 transmit a same signal).

For ease of description, as shown in FIG. 5A, in this embodiment of this application, an example in which the dielectric layer 10 includes a plurality of holes 11, and each hole 11 is correspondingly disposed with one first conductive pattern 21 is used for description.

For example, an intermediate dielectric film may be formed by using chemical vapor deposition (chemical vapor deposition, CVD), physical vapor deposition, or another deposition method, and then the hole 11 is formed on the intermediate dielectric film by using photolithography and etching methods, to obtain the dielectric layer 10 through preparation.

A material of the dielectric layer 10 may include, for example, a silicon oxide (for example, silicon dioxide SiO2), a silicon nitride (for example, silicon nitride SiN4), a silicon doped oxide, a silicon fluoride oxide, a silicon carbon doped oxide, or various dielectric materials with a low dielectric constant (k) known in a related technology and a combination thereof.

In some embodiments, as shown in FIG. 5A, the dielectric layer 10 is a single-layer film layer. In this way, the structure is simple and the process steps are few.

In some other embodiments, the dielectric layer 10 includes a plurality of dielectric film layers. Materials of the plurality of dielectric film layers may be the same, or materials of the plurality of dielectric film layers may be different.

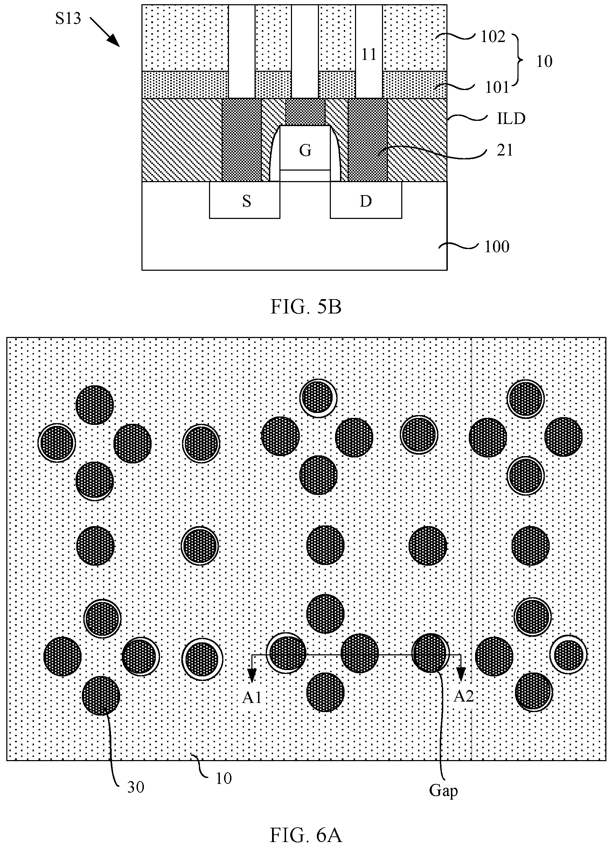

For example, as shown in FIG. 5B, the dielectric layer 10 includes a first dielectric layer 101 and a second dielectric layer 102. The first dielectric layer 101 is disposed close to the first conductive pattern 21, and a dielectric constant of the first dielectric layer 101 is greater than a dielectric constant of the second dielectric layer 102.

The first dielectric layer 101 with the larger dielectric constant is disposed at a location at which a to-be-formed conductive pillar is close to the first conductive pattern 21, so that insulation effect between the first conductive pattern 21 and the to-be-formed conductive pillar can be improved.

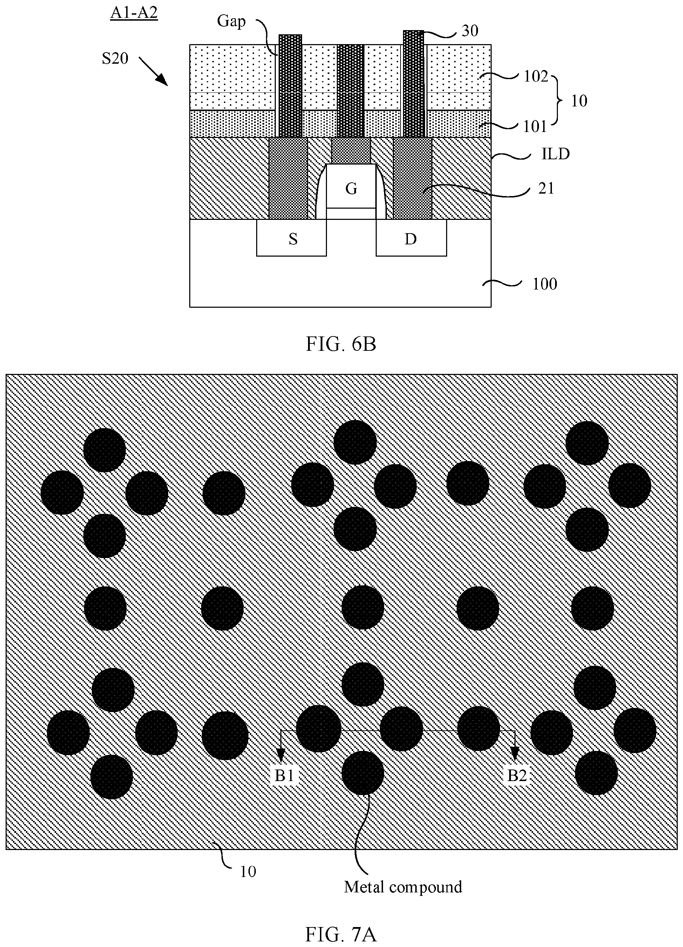

S20: As shown in FIG. 6A and FIG. 6B, by using a selective deposition (selective deposition) process, deposit from a surface of the first conductive pattern 21 in the hole 11, to form a metal pillar body 30 from bottom to top.

The selective deposition process refers to epitaxial growth performed in a region defined on the substrate. In this application, epitaxial growth starts from the surface of the first conductive pattern 21, instead of starting from a surface of the dielectric layer 10. In this application, the metal pillar body 30 is directly epitaxially grown on the surface of the metal structure, namely, the first conductive pattern 21, by using a selective epitaxial growth process. Therefore, the metal pillar body 30 is formed by using the selective deposition process, and no film layer such as a barrier layer or a nucleation layer is needed.

Therefore, in this application, the first conductive pillar is finally formed by using the selective deposition process. A bottom surface of the first conductive pillar is directly in contact with the first conductive pattern 21, a side surface of the first conductive pillar is in direct contact with the dielectric layer 10, the first conductive pillar is of a solid structure, and no void exists inside the first conductive pillar.

In some embodiments, step S20 includes:
S21: Process a surface of the hole 11 in the dielectric layer 10, to remove chemical residues and dangling bonds from a hole wall and the surface of the first conductive pattern 21.

The chemical residue may be, for example, a chemical substance remaining in a process of forming the hole 11 on the dielectric layer 10, and the dangling bond may be, for example, a chemical bond that has no electrons to be paired.

A manner of processing the surface of the hole 11 in the dielectric layer 10 may be, for example, chemical processing performed in a manner of heating, plasma treatment, inputting reducing gases, inputting oxidizing gases, or the like.

S22: By using a selective deposition (selective deposition) process, deposit from a surface of the first conductive pattern 21 in the hole 11, to form a metal pillar body 30 from bottom to top.

In the selective deposition process, a selective deposition rate is controlled, so that the metal in the hole 11 is deposited from bottom to top starting from the surface of the first conductive pattern 21, without being deposited from the hole wall at the same time. Therefore, unlike an electroplating or chemical vapor deposition process, the metal pillar body 30 formed by using the selective deposition process is a solid pillar, and no void is formed inside the metal pillar body 30. In addition, the metal pillar body 30 is formed by using the selective deposition process, and no film layer such as a barrier layer or a nucleation layer is needed.

A height of the metal pillar body 30 may be adjusted based on a depth of the hole 11 and a grinding thickness of a subsequent chemical mechanical polishing process. As shown in FIG. 6B, when a plurality of metal pillar bodies 30 are formed at the same time, heights of the plurality of metal pillar bodies 30 may be the same or different.

In this case, as shown in FIG. 6A and FIG. 6B, due to a process limitation of the selective deposition process, an irregular gap randomly appears between the metal pillar body 30 and the dielectric layer 10.

That is, gaps appear between some metal pillar bodies 30 and the dielectric layer 10, and no gap appears between some metal pillar bodies 30 and the dielectric layer 10. In addition, there are a plurality of possibilities, for example, the gap is large or small, the gap is wide or narrow, the gap is high or low, the gap circles around the metal pillar body 30, the gap exists between a part of a side surface of the metal pillar body 30 and the dielectric layer 10, the gap between the same metal pillar body 30 and the dielectric layer 10 is continuous, or the gap between the same metal pillar body 30 and the dielectric layer 10 is discontinuous.

Certainly, there may alternatively be a case in which gaps appear between all metal pillar bodies 30 and the dielectric layer 10. The structures in FIG. 6A and FIG. 6B are merely examples.

A material of the metal pillar body 30 is not limited. Optionally, the material of the metal pillar body 30 is a material with high activity and easy to be oxidized. For example, the material may include cuprum (Cu), aluminum (Al), titanium (Ti), zirconium (Zr), hafnium (Hf), vanadium (V), ruthenium (Ru), cobalt (Co), nickel (Ni), palladium (Pd), platinum (Pt), tungsten (W), argentum (Ag), aurum (Au), and copernicium (CN).

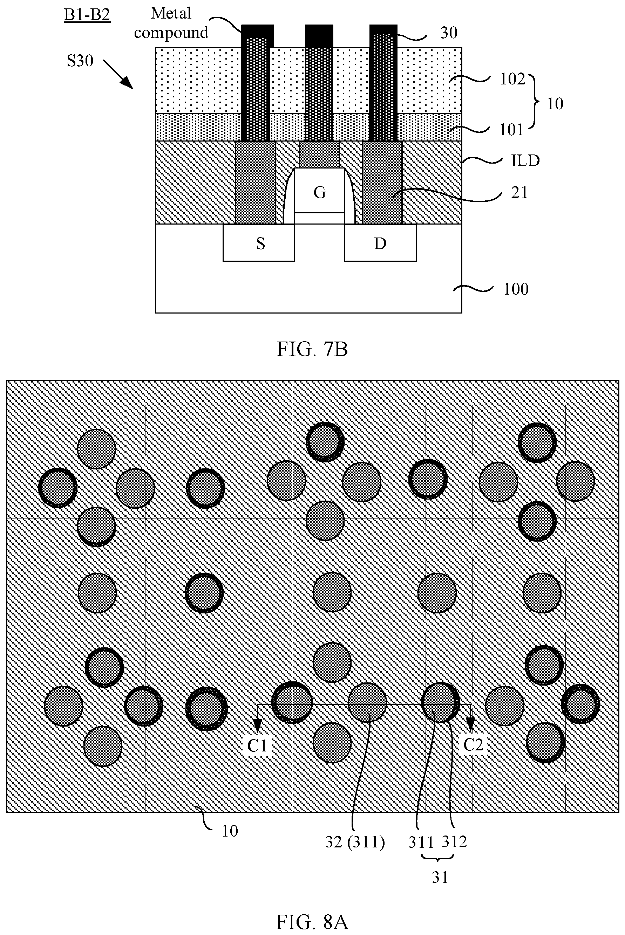

S30: As shown in FIG. 7A and FIG. 7B, perform chemical processing on the metal pillar body 30, so that a side surface that is of the metal pillar body 30 and that is not in contact with the dielectric layer 10 expands to be in contact with the dielectric layer 10.

That is, the metal pillar body 30 is processed, so that chemical reaction occurs on the metal on the surface of the metal pillar body 30. After chemical reaction occurs on the metal on the surface of the metal pillar body 30, a volume of the metal increases, so that the metal pillar body 30 expands to be in contact with the dielectric layer 10, thereby filling the gap.

In a possible implementation, step S30 includes: Perform oxidation treatment on the metal pillar body 30, so that after being oxidized, a side surface that is of the metal pillar body 30 and that is not in contact with the dielectric layer 10 expands to be in contact with the dielectric layer 10.

It may be understood that, performing oxidation treatment on the metal pillar body 30 is only oxidizing the surface that is of the metal pillar body 30 and that is not in contact with the dielectric layer 10, and a surface that is of the metal pillar body 30 and that is in contact with the dielectric layer 10 cannot be oxidized.

Refer to FIG. 6B. It can be learned that an outer surface that is of the metal pillar body 30 and that is not in contact with the dielectric layer 10 includes a top surface that is of the metal pillar body 30 and that is away from the first conductive pattern 21 and a part that is of a side surface of the metal pillar body 30 and that is not in contact with the dielectric layer 10. In this case, as shown in FIG. 7B, in the process of performing oxidation treatment on the metal pillar body 30, only the top surface and at least a part of the side surface of the metal pillar body 30 are actually oxidized, and the side surface that is of the metal pillar body 30 and that is in contact with the dielectric layer 10 is not oxidized.

For example, a material of the metal pillar body 30 includes W, and a metal oxide formed by oxidizing a side surface of the metal pillar body 30 is WOx (where 0<x<4).

For a manner of performing oxidation treatment on the metal pillar body 30, in some embodiments, the metal pillar body 30 is oxidized by using an oxygen-containing gas.

The oxygen-containing gas may be, for example, oxygen (O₂), ozone (O₃), or a mixture of oxygen and ozone. According to factors such as different oxidation stabilities and oxidation difficulties of metal pillar bodies 30, gaseous oxidation may be performed in a plasma treatment manner, or gaseous oxidation may be performed in a plasma-free treatment manner.

For a manner of performing oxidation treatment on the metal pillar body 30, in some other embodiments, the metal pillar body 30 is oxidized by using an oxidant solution.

The oxidant solution may be, for example, a solution such as hydrogen peroxide (H₂O₂). Liquid oxidation treatment may be performed in an infiltration or rinse manner.

For a manner of performing oxidation treatment on the metal pillar body 30, in some other embodiments, the metal pillar body 30 is oxidized by placing the metal pillar body 30 in an atmospheric environment for a long time.

It should be noted that, after the metal pillar body 30 is oxidized by using a chemical process, a surface that is of a formed oxide layer and that faces the inside of the metal pillar body 30 is flat (the flatness herein is not limited to absolute flatness, and may alternatively have a fluctuation amplitude). The surface that is of the oxide layer formed by oxidizing the metal pillar body 30 by placing the metal pillar body 30 in the atmospheric environment for a long time and that faces the inside of the metal pillar body 30 is not as flat as the surface that is of the oxide layer formed by oxidizing the metal pillar body 30 by using the chemical process and that faces the inside of the metal pillar body 30.

Time of oxidation treatment (oxidation treatment) for the metal pillar body 30 can be adjusted based on a selected oxidation process, an oxidation rate and other factors, and an oxidized thickness of the top surface of the metal pillar body 30 can be controlled by controlling the time of oxidation treatment. The oxidized thickness of the top surface of the metal pillar body 30 needs to be disposed based on a subsequent process of removing the oxidized part of the top surface of the metal pillar body 30, to ensure that the oxidized part of the top surface of the metal pillar body 30 can be completely removed when the oxidized part of the top surface of the metal pillar body 30 is subsequently removed.

In some embodiments, a thickness (a size in a direction perpendicular to the dielectric layer 10) of a metal oxide formed by oxidizing the top surface of the metal pillar body 30 is less than 10 nm.

For example, the thickness of the metal oxide formed by oxidizing the top surface of the metal pillar body 30 is 9 nm, 8 nm, 7 nm, 6 nm, 5 nm, 4 nm, 3 nm, 2 nm, or 1 nm.

In this way, the metal oxide formed by oxidizing the top surface of the metal pillar body 30 can be removed by using the existing chemical mechanical polishing process, without changing the process and the device.

That is, after the top surface of the metal pillar body 30 is chemically processed, the thickness of the formed metal compound is less than 10 nm, to ensure that the metal compound on the top surface of the metal pillar body 30 can be completely removed in a subsequent removal process, and conductive performance of the to-be-formed first conductive pillar is not affected.

For example, the thickness of the metal compound formed by performing chemical processing on the top surface of the metal pillar body 30 is 9 nm, 8 nm, 7 nm, 6 nm, 5 nm, 4 nm, 3 nm, 2 nm, or 1 nm.

It may be understood that, regardless of the thickness of the metal compound formed by performing chemical processing on the top surface of the metal pillar body 30, after the side surface of the metal pillar body 30 expands to be in contact with the dielectric layer 10, the metal pillar body 30 does not continue to be chemically processed.

In some embodiments, a width (a size in a direction parallel to the dielectric layer 10) of a metal oxide layer formed by oxidizing the side surface of the metal pillar body 30 is 0.5 nm to 5 nm.

After the metal pillar body 30 is oxidized by using an oxidation process, a thickness of the metal oxide layer formed by oxidizing the side surface of the metal pillar body 30 is measurable, and the thickness of the metal oxide layer is at least 0.5 nm. Based on a size of the gap generated in the selective deposition process, generally, when the thickness of the metal oxide layer is 5 nm, the gap may be filled. Therefore, the thickness of the metal oxide layer formed by oxidizing the side surface of the metal pillar body 30 is controlled to be less than 5 nm, so that the gap between the metal pillar body 30 and the dielectric layer 10 can be filled, and impact, on resistance of the metal pillar body 30, of the metal oxide layer on the side surface of the metal pillar body 30, is very small, and can be almost ignored. Therefore, a problem that the resistance of the metal pillar body 30 increases due to existence of the metal oxide layer is improved.

That is, after the side surface of the metal pillar body 30 is chemically processed, a width (a size in a direction parallel to the dielectric layer 10) of a formed metal compound layer is 0.5 nm to 5 nm, to ensure that the gap between the metal pillar body 30 and the dielectric layer 10 is filled, and impact of the metal oxide layer on the resistance of the to-be-formed first conductive pillar is reduced as much as possible.

In another possible implementation, step S30 includes: Perform nitride treatment on the metal pillar body 30, so that a side surface that is of the metal pillar body 30 and that is not in contact with the dielectric layer 10 expands to be in contact with the dielectric layer 10.

It may be understood that, performing nitride treatment on the metal pillar body 30 is only nitriding the surface that is of the metal pillar body 30 and that is not in contact with the dielectric layer 10, and a surface that is of the metal pillar body 30 and that is in contact with the dielectric layer 10 cannot be nitrided.

Refer to FIG. 6B. It can be learned that an outer surface that is of the metal pillar body 30 and that is not in contact with the dielectric layer 10 includes a top surface that is of the metal pillar body 30 and that is away from the first conductive pattern 21 and a part that is of a side surface of the metal pillar body 30 and that is not in contact with the dielectric layer 10. In this case, as shown in FIG. 7B, in the process of performing nitride treatment on the metal pillar body 30, only the top surface and at least a part of the side surface of the metal pillar body 30 are actually nitrided, and the side surface that is of the metal pillar body 30 and that is in contact with the dielectric layer 10 is not nitrided.

For example, a material of the metal pillar body 30 includes W, and a metal nitride formed by nitriding a side surface of the metal pillar body 30 is WNx (where 0<x<4).

For a manner of performing nitride treatment on the metal pillar body 30, in some embodiments, the metal pillar body 30 is nitrided by using a nitrogen-containing gas.

The nitrogen-containing gas may be, for example, nitrogen (N₂), ammonia (NH₃), or a mixture of nitrogen and ammonia. According to factors such as different nitride stabilities and nitride difficulties of metal pillar bodies 30, gaseous nitride may be performed in a plasma treatment manner, or gaseous nitride may be performed in a plasma-free treatment manner.

It should be noted that, after the metal pillar body 30 is nitrided by using a chemical process, a surface that is of a formed nitride layer and that faces the inside of the metal pillar body 30 is flat (the flatness herein is not limited to absolute flatness, and may alternatively have a fluctuation amplitude).

Time of nitride treatment for the metal pillar body 30 can be adjusted based on a selected nitride process, a nitride rate and other factors, and a nitrided thickness of the top surface of the metal pillar body 30 can be controlled by controlling the time of nitride treatment. The nitrided thickness of the top surface of the metal pillar body 30 needs to be disposed based on a subsequent process of removing the nitrided part of the top surface of the metal pillar body 30, to ensure that the nitrided part of the top surface of the metal pillar body 30 can be completely removed when the nitrided part of the top surface of the metal pillar body 30 is subsequently removed.

In some embodiments, a thickness (a size in a direction perpendicular to the dielectric layer 10) of a metal nitride formed by nitriding the top surface of the metal pillar body 30 is less than 10 nm.

In this way, the metal nitride formed by nitriding the top surface of the metal pillar body 30 can be removed by using the existing chemical mechanical polishing process, without changing the process and the device.

In some embodiments, a width (a size in a direction parallel to the dielectric layer 10) of a metal nitride layer formed by nitriding the side surface of the metal pillar body 30 is 0.5 nm to 5 nm.

In this way, it is ensured that the metal nitride layer fills the gap between the metal pillar body 30 and the dielectric layer 10, and impact of the metal nitride layer on the resistance of the to-be-formed first conductive pillar is reduced as much as possible.

In still another possible implementation, step S30 includes: Perform oxidation treatment and nitride treatment on the metal pillar body 30, so that after being oxidized and nitrided, a side surface that is of the metal pillar body 30 and that is not in contact with the dielectric layer 10 expands to be in contact with the dielectric layer 10.

It may be understood that, performing oxidation treatment and nitride treatment on the metal pillar body 30 is only oxidizing and nitriding the surface that is of the metal pillar body 30 and that is not in contact with the dielectric layer 10, and a surface that is of the metal pillar body 30 and that is in contact with the dielectric layer 10 cannot be oxidized and nitrided.

Refer to FIG. 6B. It can be learned that an outer surface that is of the metal pillar body 30 and that is not in contact with the dielectric layer 10 includes a top surface that is of the metal pillar body 30 and that is away from the first conductive pattern 21 and a part that is of a side surface of the metal pillar body 30 and that is not in contact with the dielectric layer 10. In this case, as shown in FIG. 7B, in the process of performing oxidation treatment and nitride treatment on the metal pillar body 30, only the top surface and at least a part of the side surface of the metal pillar body 30 are actually oxidized and nitrided, and the side surface that is of the metal pillar body 30 and that is in contact with the dielectric layer 10 is not oxidized and nitrided.

For example, a material of the metal pillar body 30 includes W, and a metal oxynitride formed by oxidizing and nitriding a side surface of the metal pillar body 30 is WOxNy (where 0<x<4, and 0<y<4).

For a manner of performing oxidation treatment and nitride treatment on the metal pillar body 30, in some embodiments, the metal pillar body 30 is oxidized and nitrided by using a gas containing oxygen and nitrogen.

The gas containing oxygen and nitrogen may be, for example, nitrous oxide (N₂O) or a mixture of nitrogen and oxygen. According to factors such as different oxidation and nitride stabilities and oxidation and nitride difficulties of metal pillar bodies 30, gaseous oxidation and nitride may be performed in a plasma treatment manner, or gaseous oxidation and nitride may be performed in a plasma-free treatment manner.

Time of oxidation treatment and nitride treatment for the metal pillar body 30 can be adjusted based on a selected oxidation and nitride process, an oxidation and nitride rate and other factors, and an oxidized and nitrided thickness of the top surface of the metal pillar body 30 can be controlled by controlling the time of oxidation treatment and nitride treatment. The oxidized and nitrided thickness of the top surface of the metal pillar body 30 needs to be disposed based on a subsequent process of removing the oxidized and nitrided part of the top surface of the metal pillar body 30, to ensure that the oxidized and nitrided part of the top surface of the metal pillar body 30 can be completely removed when the oxidized and nitrided part of the top surface of the metal pillar body 30 is subsequently removed.

In some embodiments, a thickness (a size in a direction perpendicular to the dielectric layer 10) of a metal oxynitride formed by oxidizing and nitriding the top surface of the metal pillar body 30 is less than 10 nm.

In this way, the metal oxynitride formed by oxidizing and nitriding the top surface of the metal pillar body 30 can be removed by using the existing chemical mechanical polishing process, without changing the process and the device.

In some embodiments, a width (a size in a direction parallel to the dielectric layer 10) of a metal oxynitride layer formed by oxidizing and nitriding the side surface of the metal pillar body 30 is 0.5 nm to 5 nm.

In this way, it is ensured that the metal oxynitride layer fills the gap between the metal pillar body 30 and the dielectric layer 10, and impact of the metal oxynitride layer on the resistance of the to-be-formed first conductive pillar is reduced as much as possible.

That is, when chemical processing is performed on the metal pillar body 30, oxidation treatment may be performed on the metal pillar body 30, or nitride treatment may be performed on the metal pillar body 30, or oxidation and nitride treatment may be performed on the metal pillar body 30. Certainly, other chemical processing that can enable the metal pillar body 30 to expand may alternatively be performed on the metal pillar body 30. This is not limited in this embodiment of this application.

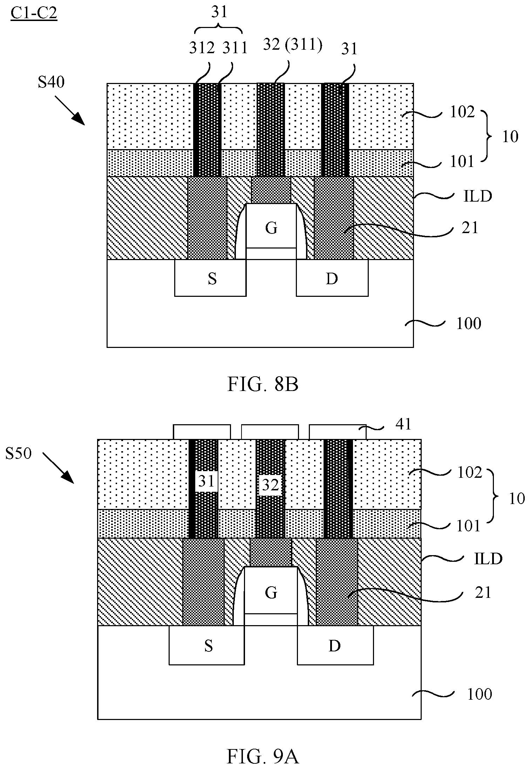

S40: As shown in FIG. 8A and FIG. 8B, remove a chemically processed part of the top surface of the metal pillar body 30 to form a first conductive pillar 31.

The first conductive pillar 31 includes a metal pillar 311 and a metal compound layer 312, and the metal compound layer 312 is located on a side surface of the metal pillar 311. A part that is of the metal pillar body 30 and that is not chemically processed is the metal pillar 311, and a chemically processed part of a side surface of the metal pillar body 30 is the metal compound layer 312.

In this case, a metal included in the metal pillar 311 (for example, the W pillar) formed by using the process is the same as a metal included in the metal compound layer 312 (for example, the WOx layer, the WNx layer, or the WOxNy layer), and both are metals (for example, W) used for forming the metal pillar body 30.

It should be understood that, in step S30, if oxidation treatment is performed on the metal pillar body 30, the metal compound layer 312 is a metal oxide layer. In step S30, if nitride treatment is performed on the metal pillar body 30, the metal compound layer 312 is a metal nitride layer. In step S30, if oxidation treatment and nitride treatment are performed on the metal pillar body 30, the metal compound layer 312 is a metal oxynitride layer.

For example, the chemical mechanical polishing process may be used to remove the chemically processed part of the top surface of the metal pillar body 30, and a thickness of a metal compound formed by performing chemical processing on the top surface of the metal pillar body 30 needs to be less than a thickness removed by using the chemical mechanical polishing process. Certainly, the metal compound formed by performing chemical processing on the top surface of the metal pillar body 30 may be removed by using another process. This is not limited in this embodiment of this application.

In some embodiments, before the chemical mechanical polishing process is performed, a top metal layer is covered on a side that is of the dielectric layer 10 and that is away from the first conductive pattern 21, and the top metal layer covers the dielectric layer 10 and the conductive pillar body 30.

A ratio of heights between a plurality of conductive pillar bodies 30 and between the conductive pillar body 30 and the dielectric layer 10 can be reduced by disposing the top metal layer on the surface of the dielectric layer 10, so that a grinding speed and a grinding height are adjusted, and the chemically processed part of the top surface of the metal pillar body 30 is completely removed without excessively grinding the conductive pillar body 30.

In a chip preparation process, after the metal pillar body 30 is prepared, chemical mechanical polishing usually needs to be performed on the metal pillar body 30, so that surfaces of all the metal pillar bodies 30 are flush with each other and are flush with the surface of the dielectric layer 10. Therefore, the chemical mechanical polishing process is used to remove the chemically processed part of the top surface of the metal pillar body 30, and the chemically processed part of the top surface of the metal pillar body 30 can be removed without adding a new process. Therefore, process costs are low, and production efficiency is high.

Still refer to FIG. 8A and FIG. 8B. After step S40 is performed, a side surface of a formed first metal pillar 31 is in contact with the dielectric layer 10, and no gap exists between the first metal pillar 31 and the dielectric layer 10. It is explained herein that, that the first metal pillar 31 is in contact with the dielectric layer 10 should be understood as that the entire side surface of the first metal pillar 31 is in contact (or closely contact) with the dielectric layer 10. Alternatively, it is understood that the entire side surface of the first metal pillar 31 is in contact with the hole wall of the corresponding hole 11 in the dielectric layer 10.

Certainly, in the process of forming the plurality of metal pillar bodies 30, if a special case occurs, gaps between some metal pillar bodies 30 and the dielectric layer 10 are extremely large. After steps S30 and S40 are performed, a gap may still exist between the formed first metal pillar 31 and the dielectric layer 10. This also falls within the protection scope of this embodiment of this application. For the chip formed by using the preparation method in this embodiment of this application, a probability of the foregoing case is low, and the foregoing case almost does not occur.

The metal compound layer 312 and a side surface that is of the metal pillar 311 and that is not covered by the metal compound layer 312 are in contact with the dielectric layer 10, and contact between the first conductive pillar 31 and the dielectric layer 10 is different based on different degrees of coverage of the metal compound layer 312 for the metal pillar 311.

In addition, if the metal pillar body 30 is deposited on the surface of the first conductive pattern 21, the formed first metal pillar 31 is in contact with the first conductive pattern 21.

In some embodiments, as shown in FIG. 8B, a part of a side surface of the metal pillar 311 on the left side of the view angle in FIG. 8B is covered by the metal compound layer 312.

In this case, a side surface of the first conductive pillar 31 includes two parts, one part is a side surface that is of the metal pillar 311 and that is not covered by the metal compound layer 312, and the other part is a side surface of the metal compound layer 312. In this case, that the first conductive pillar 31 is in contact with the dielectric layer 10 may be understood as that the first conductive pillar 31 is in contact with the dielectric layer 10 through the side surface that is of the metal pillar 311 and that is not covered by the metal compound layer 312 and the side surface of the metal compound layer 312.

That is, a region in which the side surface that is of the metal pillar 311 and that is not covered by the metal compound layer 312 is located is directly in contact with the dielectric layer 10, and a region in which the side surface that is of the metal pillar 311 and that is covered by the metal compound layer 312 is located is in contact with the dielectric layer 10 through the metal compound layer 312, so that all regions of the side surface of the first conductive pillar 31 are in contact with the dielectric layer 10.

In some other embodiments, still refer to FIG. 8B. All side surfaces of the metal pillar 311 on the right side of the view angle in FIG. 8B are covered by the metal compound layer 312.

In this case, a side surface that is of the metal pillar 31 and that is not covered by the metal compound layer 312 does not exist, and the side surface of the metal compound layer 312 is the side surface of the first conductive pillar 31. In this case, that the first conductive pillar 31 is in contact with the dielectric layer 10 may be understood as that the first conductive pillar 31 is in contact with the dielectric layer 10 through the metal compound layer 312, so that all regions of the side surface of the first conductive pillar 31 are in contact with the dielectric layer 10.

It should be emphasized that, thicknesses at all locations of the metal compound layer 312 included in the first conductive pillar 31 may be the same (for example, the metal compound layer 312 included in the first conductive pillar 31 on the left side of the view angle in FIG. 8B), and thicknesses at all locations of the metal compound layer 312 included in the first conductive pillar 31 may alternatively be different (for example, the metal compound layer 312 included in the first conductive pillar 31 on the right side of the view angle in FIG. 8B). This is not limited in this embodiment of this application.

In addition, materials at all locations of the metal compound layer 312 included in the first conductive pillar 31 may be the same, and materials at all locations of the metal compound layer 312 included in the first conductive pillar 31 may alternatively be different. Alternatively, it is understood that, oxygen content and/or nitrogen content of materials at all locations of the metal compound layer 312 included in the first conductive pillar 31 may be the same, and oxygen content and/or nitrogen content of materials at all locations of the metal oxide layer 312 included in the first conductive pillar 31 may alternatively be different.

For example, a material of the metal compound layer 312 is WOx (where 0<x<4), and values of x in WOx at all locations of the metal compound layer 312 may be different. Alternatively, for example, a material of the metal compound layer 312 is WNx (where 0<x<4), and values of x in WNx at all locations of the metal compound layer 312 may be different. Alternatively, for example, a material of the metal compound layer 312 is WOxNy (where 0<x<4, 0<y<4), and values of x and y in WOxNy at all locations of the metal compound layer 312 may be different.

In some embodiments, refer to FIG. 8B. The dielectric layer 10 has a plurality of holes 11. After the first conductive pillar 31 is prepared in the holes 11 by using the foregoing steps, the chip includes a plurality of first conductive pillars 31.

In this case, for example, as shown in FIG. 8B, widths of a plurality of metal compound layers 312 included in the plurality of first conductive pillars 31 are completely different.

Alternatively, for example, widths of a plurality of metal compound layers 312 included in the plurality of first conductive pillars 31 are not completely the same. It may alternatively be understood that, in the plurality of metal compound layers 312 included in the plurality of first conductive pillars 31, some metal compound layers 312 have a same thickness, and some metal compound layers 312 have different thicknesses.

Alternatively, for example, widths of the plurality of metal compound layers 312 included in the plurality of first conductive pillars 31 are completely the same.

When the metal pillar body 30 is formed by using the selective deposition process, a width of the gap between the metal pillar body 30 and the dielectric layer 10 is random and irregular. Therefore, a width of the finally formed metal compound layer 312 is not limited, and the metal compound layer 312 may have various thicknesses, sizes, shapes, and locations. This is not limited in this embodiment of this application.

For example, materials of the plurality of metal compound layers 312 included in the plurality of first conductive pillars 31 are completely different. For example, a material of the metal compound layer 312 is WOx, and values of x in WOx at all locations of the metal compound layer 312 are completely different.

Alternatively, for example, materials of the plurality of metal compound layers 312 included in the plurality of first conductive pillars 31 are not completely the same. For example, a material of the metal compound layer 312 is WOx, and values of x in WOx at all locations of the metal compound layer 312 are not completely the same.

Alternatively, for example, materials of the plurality of metal compound layers 312 included in the plurality of first conductive pillars 31 are completely the same. For example, a material of the metal compound layer 312 is WOx, and values of x in WOx at all locations of the metal compound layer 312 are the same.

There are a plurality of possibilities for oxygen content/nitrogen content of the plurality of formed metal compound layers 312 due to factors such as different sizes of gaps between the metal pillar bodies 30 and the dielectric layer 10, different chemical processing manners of the metal pillar bodies 30, different oxygen content and/or nitrogen content during chemical processing, and different chemical processing duration. This is not limited in this embodiment of this application.

Still refer to FIG. 8A and FIG. 8B. In some embodiments, the dielectric layer 10 has a plurality of holes, and in step S20, the selective deposition process is used to form a plurality of metal pillar bodies 30. When the first conductive pillar 31 is formed, a second conductive pillar 32 is further formed.

A main difference between the second conductive pillar 32 and the first conductive pillar 31 lies in that the second conductive pillar 32 includes the metal pillar and does not include the metal compound layer.

The metal pillar is disposed in the hole 11 of the dielectric layer 10, or it is understood that the dielectric layer 10 wraps a periphery of the metal pillar. A side surface of the metal pillar is in contact with the hole wall of the hole 11 in the dielectric layer 10, and a bottom surface of the second conductive pillar 32 is in contact with the first conductive pattern 21.

One first conductive pattern 21 may be coupled to only one or more first conductive pillars 31, one first conductive pattern 21 may be coupled to only one or more second conductive pillars 32, or one first conductive pattern 21 may be coupled to one (or more) first conductive pillars 31 and one (or more) second conductive pillars 32.

As shown in FIG. 7A and FIG. 7B, in step S30, outer surfaces that are of all the metal pillar bodies 30 and that are not in contact with the dielectric layer 10 are chemically processed. As shown in FIG. 8A and FIG. 8B, after step S40, metal compounds on top surfaces of all the metal pillar bodies 30 are removed. For a metal pillar body 30 whose side surface is not chemically processed, after the metal compound on the top surface of the metal pillar body 30 is removed, the second conductive pillar 32 is formed. For a metal pillar body 30 whose side surface is chemically processed, after the metal compound on the top surface of the metal pillar body 30 is removed, the first conductive pillar 31 is formed. Therefore, a metal included in the first conductive pillar 31 is the same as a metal included in the second conductive pillar 32, and both are the same as a metal included in the metal pillar body 30.

It should be noted herein that, when the plurality of metal pillar bodies 30 are formed, an irregular gap randomly appears between the metal pillar body 30 and the dielectric layer 10. Therefore, the metal compound layer 312 also appears randomly and irregularly. In this case, the first conductive pillar 31 and the second conductive pillar 32 are also randomly arranged, and there is no arrangement rule. Even in chips of a same batch, distribution of the first conductive pillar 31 and the second conductive pillar 32 may be different.

S50: As shown in FIG. 9A, form a second conductive pattern 41 on a side that is of the dielectric layer 10 and that is away from the first conductive pattern 21, where the second conductive pattern 41 is coupled to the first conductive pillar 31.

A shape, a function, and a material of the second conductive pattern 41 are not limited in this embodiment of this application, and may be properly disposed based on an application scenario.

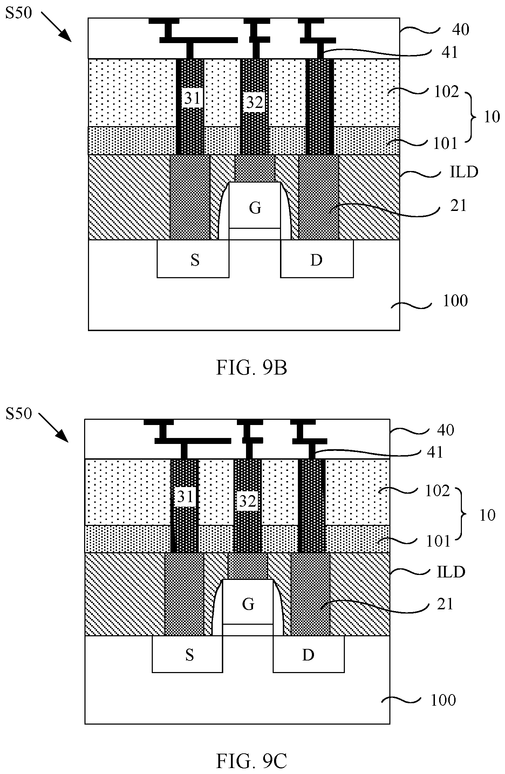

In some embodiments, as shown in FIG. 9B, the second conductive pattern 41 is a conductive pattern included in a first redistribution layer 40. In other words, the second conductive pattern 41 is a conductive pattern in the redistribution layer prepared by using a back-end process.

For example, the second conductive pattern 41 is a conductive pattern in a wiring layer that is in the first redistribution layer 40 and that is closest to the dielectric layer 10. The second conductive pattern 41 may be a columnar shape, the second conductive pattern 41 may be a line shape, or the second conductive pattern 41 may be another shape. This is not limited in this embodiment of this application.

In some embodiments, as shown in FIG. 9B, the chip includes a plurality of second conductive patterns 41, some of the plurality of second conductive patterns 41 are coupled to the first conductive pillar 31, and some of the plurality of second conductive patterns 41 are coupled to the second conductive pillar 32.

One second conductive pattern 41 may be coupled to only one or more first conductive pillars 31, one second conductive pattern 41 may be coupled to only one or more second conductive pillars 32, or one second conductive pattern 41 may be coupled to one (or more) first conductive pillars 31 and one (or more) second conductive pillars 32.

That is, two ends of the first conductive pillar 31 are respectively coupled to the first conductive pattern 21 and the second conductive pattern 41, and two ends of the second conductive pillar 32 are respectively coupled to the first conductive pattern 21 and the second conductive pattern 41.

According to the chip preparation method provided in this embodiment of this application, after the metal pillar body 30 is formed by using the selective deposition process, self-healing is performed on an irregular gap defect between the metal pillar body 30 and the dielectric layer 10 by using a chemical processing manner such as oxidation treatment and/or nitride treatment. As long as the gap defect exists between the metal pillar body 30 and the dielectric layer 10, and after self-healing is performed by using chemical processing, a volume of the metal pillar body 30 expands to generate a metal compound, and the metal compound fills the gap defect between the metal pillar body 30 and the dielectric layer 10, to effectively prevent the first conductive pattern 21 from being damaged by a solution such as a lapping liquid, a cleaning fluid, or an etchant.

The following describes a structure of the chip provided in an embodiment of this application. Refer to FIG. 9B. The chip provided in this embodiment of this application includes a first conductive pillar 31, a dielectric layer 10, a first conductive pattern 21, and a second conductive pattern 41.

There may be one or more first conductive pillars 31. In FIG. 9B, an example in which the chip includes a plurality of first conductive pillars is used for illustration. Regardless of whether there is one or more first conductive pillars 31, the dielectric layer 10 wraps a periphery of each first conductive pillar 31, and is in contact with a side surface of each first conductive pillar 31. Alternatively, it is understood that each first conductive pillar 31 is disposed in the dielectric layer 10, and also runs through the dielectric layer 10 in a thickness direction of the dielectric layer 10.

In addition, a shape of the first conductive pillar 31 is not limited in this embodiment of this application. The first conductive pillar 31 may be a cylindrical shape, a rectangular column shape, a rectangular shape, or the like.

The first conductive pattern 21 and the second conductive pattern 41 are located on two opposite sides of the first conductive pillar 31, or it is understood that the first conductive pattern 21 and the second conductive pattern 41 are located on two opposite sides of the dielectric layer 10. The first conductive pattern 21 and the second conductive pattern 41 are correspondingly coupled to two ends of the first conductive pillar 31.

Shapes of the first conductive pattern 21 and the second conductive pattern 41 are not limited in this embodiment of this application, provided that the first conductive pattern 21 and the second conductive pattern 41 can be conductive.

In some embodiments, the first conductive pattern 21 is contact coupled to the first conductive pillar 31. The second conductive pattern 41 may be contact coupled to the first conductive pillar 31, and the second conductive pattern 41 may alternatively be indirectly coupled to the first conductive pillar 31. For specific structures of the first conductive pattern 21 and the second conductive pattern 41 in the chip, refer to related descriptions of the first conductive pattern 21 and the second conductive pattern 41 in the foregoing description of the chip preparation method.

Still refer to FIG. 9B. The first conductive pillar 31 includes a metal pillar 311 and a metal compound layer 312, the metal compound layer 312 is located between the metal pillar 311 and the dielectric layer 10, and the metal compound layer 312 covers at least a part of a side surface of the metal pillar 311. The first conductive pillar 31 is in contact with the dielectric layer 10 through the metal compound layer 312 and a side surface that is of the metal pillar 311 and that is not covered by the metal compound layer 312.

In some embodiments, as shown in FIG. 9B, a part of a side surface of the metal pillar 311 on the left side of the view angle in FIG. 9B is covered by the metal compound layer 312. In this case, that the first conductive pillar 31 is in contact with the dielectric layer 10 may be understood as that the first conductive pillar 31 is in contact with the dielectric layer 10 through the side surface that is of the metal pillar 311 and that is not covered by the metal compound layer 312 and the side surface of the metal compound layer 312.

In some other embodiments, still refer to FIG. 9B. All side surfaces of the metal pillar 311 on the right side of the view angle in FIG. 9B are covered by the metal compound layer 312. In this case, a side surface that is of the metal pillar 311 and that is not covered by the metal compound layer 312 does not exist. In this case, that the first conductive pillar 31 is in contact with the dielectric layer 10 may be understood as that the first conductive pillar 31 is in contact with the dielectric layer 10 through the metal compound layer 312, so that all regions of the side surface of the first conductive pillar 31 are in contact with the dielectric layer 10.

It should be noted that, for example, the metal pillar 311 is a rectangle, and a part of a side surface of the metal pillar 311 is covered by the metal compound layer 312, which is not limited to that one or more side surfaces of the four side surfaces of the metal pillar 311 are covered by the metal compound layer 312. As shown in FIG. 9C, a partial region of one side surface of the metal pillar 311 may be covered by the metal compound layer 312, and a partial region may be not covered by the metal compound layer 312. Certainly, there may be other cases, which are not exhaustive in this embodiment of this application.

In some embodiments, the metal pillar 311 is formed by using the selective deposition process. In this way, the metal pillar 311 is obtained through deposition from bottom to top from the surface of the first conductive pattern 21, to avoid void existing inside the metal pillar 311 as far as possible, and no film layer such as a barrier layer is needed.

In some embodiments, the metal compound layer 312 is obtained by performing chemical processing on the side surface of the metal pillar 311. In this case, a metal included in the metal pillar 311 is the same as a metal included in the metal compound layer 312.

Material characteristics of the metal pillar 311 and the metal compound layer 312 may be similar by disposing the metal included in the metal pillar 311 to be the same as the metal included in the metal compound layer 312, thereby improving adhesiveness between the metal pillar 311 and the metal compound layer 312, and reducing a defect caused by separation of the metal compound layer 312 and the metal pillar 311.

Alternatively, for example, a metal included in the metal pillar 311 is different from a metal included in the metal compound layer 312.

Optionally, the metal compound layer 312 includes a metal oxide material. For example, the metal compound layer 312 is obtained by performing oxidation treatment on the side surface of the metal pillar 311.

Alternatively, optionally, the metal compound layer 312 includes a metal nitride material. For example, the metal compound layer 312 is obtained by performing nitride treatment on the side surface of the metal pillar 311.

Alternatively, optionally, the metal compound layer 312 includes a metal oxide material and a metal nitride material. For example, the metal compound layer 312 is obtained by performing oxidation and nitride treatment on the side surface of the metal pillar 311.

Alternatively, optionally, the metal compound layer 312 includes a metal oxynitride material. For example, the metal compound layer 312 is obtained by performing oxidation treatment and nitride treatment on the side surface of the metal pillar 311.

Alternatively, optionally, the metal compound layer 312 includes a metal oxide material and a metal oxynitride material. For example, the metal compound layer 312 is obtained by performing oxidation treatment and nitride treatment on the side surface of the metal pillar 311.

Alternatively, optionally, the metal compound layer 312 includes a metal nitride material and a metal oxynitride material. For example, the metal compound layer 312 is obtained by performing oxidation treatment and nitride treatment on the side surface of the metal pillar 311.

Alternatively, optionally, the metal compound layer 312 includes a metal oxide material, a metal nitride material, and a metal oxynitride material. For example, the metal compound layer 312 is obtained by performing oxidation treatment and nitride treatment on the side surface of the metal pillar 311.

In some other embodiments, the metal compound layer 312 is formed by using an independent process.

In other words, a manner of forming the metal compound layer 312 is not limited in this embodiment of this application, and the manner of forming the metal compound layer 312 in the foregoing schematic chip preparation method is merely an example.

In some embodiments, a width of the metal compound layer 312 included in the first conductive pillar 31 is 0.5 nm to 5 nm.

The width of the metal oxide layer 312 is controlled to be less than 5 nm, so that the gap between the metal pillar body 30 and the dielectric layer 10 can be filled, and impact of the metal oxide layer 312 on the resistance of the metal pillar body 30 is very small, and can be almost ignored. Therefore, a problem that the resistance of the first conductive pillar 31 increases due to existence of the metal oxide layer 312 is improved.

It can be learned from the foregoing description of the chip preparation method that, when the chip includes a plurality of first conductive pillars 31, oxygen content and/or nitrogen content of metal compound layers 312 included in the plurality of first conductive pillars 31 are not limited to be the same. Widths of the metal compound layers 312 included in the plurality of first conductive pillars 31 are not limited to be the same either, and widths at all locations of the metal compound layer 312 included in the same first conductive pillar 31 are not limited to be the same either.

Still refer to FIG. 9B. In some embodiments, the chip further includes a second conductive pillar 32, the second conductive pillar 32 is the metal pillar 311, and the second conductive pillar 32 does not include the metal compound layer 312. The second conductive pillar 32 and the first conductive pillar 31 are disposed in parallel, and two ends of the second conductive pillar 32 are respectively coupled to the first conductive pattern 21 and the second conductive pattern 41. The second conductive pillar 32 is disposed in the dielectric layer 10, the second conductive pillar 32 runs through the dielectric layer 10 in a thickness direction of the dielectric layer 10, and the dielectric layer 10 is in contact with a side surface of the metal pillar 311.

In some embodiments, depth-to-width ratios of the first conductive pillar 31 and the second conductive pillar 32 are greater than 2:1.

For example, depth-to-width ratios of the first conductive pillar 31 and the second conductive pillar 32 are respectively 3:1, 4:1, 5:1, 6:1, 7:1, 8:1, 9:1, 10:1, 11:1, 12:1, or greater. The depths of the first conductive pillar 31 and the second conductive pillar 32 refer to a size of the depth of the first conductive pillar 31 and a size of the depth of the second conductive pillar 32 in a direction perpendicular to the dielectric layer 10. The widths of the first conductive pillar 31 and the second conductive pillar 32 refer to a size of the width of the first conductive pillar 31 and a size of the width of the second conductive pillar 32 in a direction parallel to the dielectric layer 10.

An example in which the first conductive pattern 21 is disposed between the first conductive pillar 31 (or the second conductive pillar 32) and the electronic component 20 is used for illustration. Certainly, the first conductive pillar 31 and the second conductive pillar 32 may be directly coupled to the electronic component 20 without the bottom metal, and a conductive portion of the electronic component 20 is the first conductive pattern 21.

In the chip provided in this embodiment of this application, the first conductive pattern 21 is coupled to the second conductive pattern 41 through the first conductive pillar 31, or some of the first conductive patterns 21 are coupled to the second conductive patterns 41 through the second conductive pillar 32. Both the first conductive pillar 31 and the second conductive pillar 32 are directly in contact with the dielectric layer 10 without the film layer such as the barrier layer. In this way, no film layer such as the barrier layer occupies space, and the depth-to-width ratios of the first conductive pillar 31 and the second conductive pillar 32 can be increased. In addition, the resistance of the first conductive pillar 31 and the second conductive pillar 32 is not affected by the film layer such as the barrier layer, and the resistance of the first conductive pillar 31 and the second conductive pillar 32 can be effectively reduced.

On this basis, the first conductive pillar 31 includes the metal pillar 311 and the metal compound layer 312. A gap defect existing between the formed metal pillar 311 and the dielectric layer 10 due to a process limitation can be filled by using the metal compound layer 312. This can avoid as far as possible damage to the first conductive pattern 21 at the bottom of the first conductive pillar 31 and eventual failure of the chip that are caused by penetration of a solution, for example, an acid lapping liquid, a cleaning fluid, or an etchant, into the gap between the first conductive pillar 31 and the dielectric layer 10.

In addition, because the gap between the metal pillar 311 and the dielectric layer 10 is very small, a volume of the metal compound layer 312 located in the gap is also very small. Therefore, impact of the metal compound layer 312 on the resistance of the first conductive pillar 31 is very small and can be almost ignored, and existence of the metal compound layer 312 does not cause an increase in the resistance of the first conductive pillar 31.

In some embodiments, an embodiment of this application further provides a chip. The chip is a chip obtained by packaging the foregoing 2D die.

### Example 2

An embodiment of this application provides a chip, and the chip is a 3D die.

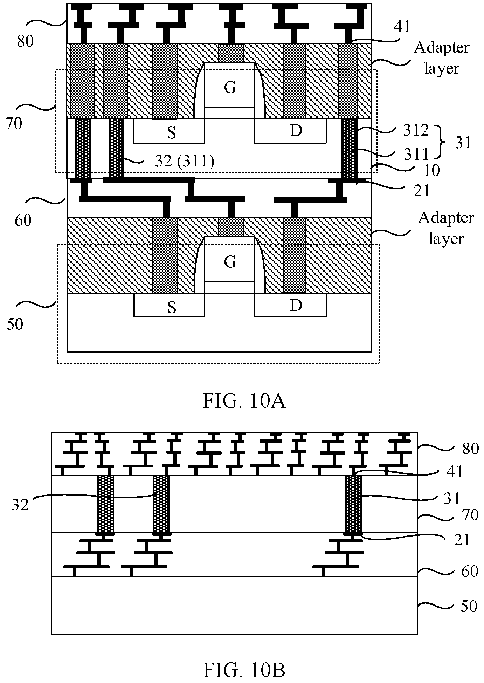

As shown in FIG. 10A, the chip includes a first integrated circuit module 50, a second redistribution layer 60, a second integrated circuit module 70, and a third redistribution layer 80 that are sequentially stacked.

A surface that is of the third redistribution layer 80 and that is away from the second integrated circuit module 70 is an active surface of the chip, and a surface that is of the first integrated circuit module 50 and that is away from the second redistribution layer 60 is a non-active surface of the chip.

The first integrated circuit module 50 and the second integrated circuit module 70 may be understood as structures that include a plurality of circuit electronic components and that are prepared in a front end of line.

A function implemented by the first integrated circuit module 50 is not limited in this embodiment of this application, and a structure of an electronic component included in the first integrated circuit module 50 is not limited either. For example, the first integrated circuit module 50 includes a plurality of electronic components, and the plurality of electronic components are coupled in series and in parallel by using structures prepared by using a subsequent process, to implement some functions. Similarly, a function implemented by the second integrated circuit module 70 is not limited in this embodiment of this application, and a structure of an electronic component included in the second integrated circuit module 70 is not limited either. For example, the second integrated circuit module 70 includes a plurality of electronic components, and the plurality of electronic components are coupled in series and in parallel by using structures prepared by using a subsequent process, to implement some functions. In FIG. 10A, one CMOS included in the first integrated circuit module 50 is used only as an example for illustration, and one CMOS included in the second integrated circuit module 70 is used as an example for illustration.

For example, the first integrated circuit module 50 is a circuit structure of a logical area, and the second integrated circuit module 70 is a circuit structure of a memory area; or the first integrated circuit module 50 is a circuit structure of a logical area, and the second integrated circuit module 70 is a circuit structure of a detector.

It should be noted that the chip may include an contact layerformed through preparation in a mid end of line. Certainly, based on a requirement, the chip may not include the contact layerformed through preparation in the mid end of line.

Still refer to FIG. 10A. The second redistribution layer 60 includes a first conductive pattern 21, and the first conductive pattern 21 is coupled to the first integrated circuit module 50. For example, a wiring layer that is in the second redistribution layer 60 and that is closest to the second integrated circuit module 70 includes a first conductive pattern 21, and the first conductive pattern 21 is contact coupled to electrodes (for example, a source S, a drain D, and a gate D) of electronic components in the first integrated circuit module 50.

The third redistribution layer 80 includes a second conductive pattern 41. For example, a wiring layer that is in the third redistribution layer 80 and that is closest to the second integrated circuit module 70 includes the second conductive pattern 41. A first conductive pillar 31 runs through the second integrated circuit module 70, and the first conductive pillar 31 is coupled to the second conductive pattern 41 through a conductive pillar in the contact layer(when the chip does not include the adapter layer, the first conductive pillar 31 may be directly contact coupled to the second conductive pattern 41). The third redistribution layer 80 is further coupled to the second integrated circuit module 70.

In other words, the chip shown in this example includes at least two integrated circuit modules, and FIG. 10A uses only the first integrated circuit module 50 and the second integrated circuit module 70 as an example for illustration. As shown in FIG. 10B, from a macroscopic perspective, a signal of the active surface of the chip is transmitted to the first integrated circuit module 50 through the third redistribution layer 80, the first conductive pillar 31, and the second redistribution layer 60 in sequence. The signal of the active surface of the chip is further transmitted to the second integrated circuit module 70 through the third redistribution layer 80.

Still refer to FIG. 10A. The first conductive pillar 31 includes a metal pillar 311 and a metal compound layer 312, the metal compound layer 312 is located between the metal pillar 311 and the dielectric layer 10, the metal compound layer 312 covers at least a part of a side surface of the metal pillar 311, and the metal compound layer 312 and a side surface that is of the metal pillar 311 and that is not covered by the metal compound layer 312 are in contact with the dielectric layer 10.

In some embodiments, the chip further includes a second conductive pillar 32, and the second conductive pillar 32 includes the metal pillar 311, and does not include the metal compound layer 312.

Structures of the first conductive pillar 31 and the second conductive pillar 32 may be the same as structures of the first conductive pillar 31 and the second conductive pillar 32 in Example 1. For details, refer to related descriptions in Example 1. Details are not described herein again.

It should be emphasized herein that the material of the dielectric layer 10 in Example 1 is an insulation material. In this example, the first conductive pillar 31 and the second conductive pillar 32 run through the second integrated circuit module 70. Therefore, the dielectric layer 10 wrapped around peripheries of the first conductive pillar 31 and the second conductive pillar 32 is a substrate of the second integrated circuit module 70. In other words, a material of the dielectric layer 10 is a semiconductor.

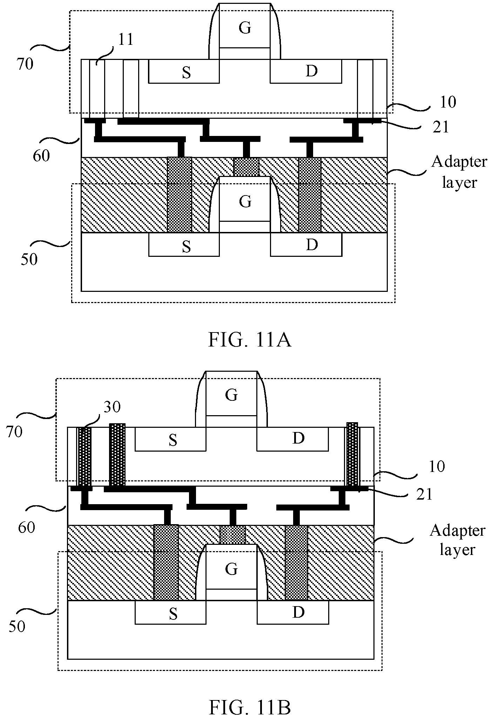

The following shows an example of a chip preparation method provided in an embodiment of this application, including:
S10: As shown in FIG. 11A, provide a dielectric layer 10 and a first conductive pattern 21 located on a side of the dielectric layer 10.

A method for preparing the structure shown in FIG. 11A is not limited in this embodiment of this application. For example, a structure including a first integrated circuit module 50, an adapter layer, and a second redistribution layer 60 may be first formed in a front end of line, a mid end of line, and a back end of line, and then a second integrated circuit module 70 is formed on the foregoing structure in the front end of line. The second integrated circuit module 70 includes the dielectric layer 10, and the second redistribution layer 60 includes the first conductive pattern 21.

As shown in FIG. 11A, the dielectric layer 10 includes a hole 11, the hole 11 is located above the first conductive pattern 21, and the hole 11 is in contact with the first conductive pattern 21.

S20: As shown in FIG. 11B, by using a selective deposition process, deposit from a surface of the first conductive pattern 21 in the hole 11, to form a metal pillar body 30 from bottom to top.

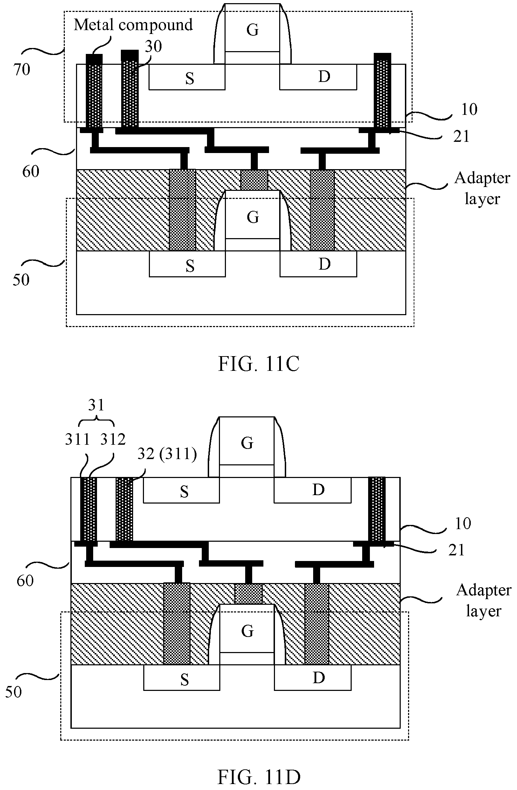

S30: As shown in FIG. 11C, perform chemical processing on the metal pillar body 30, so that a side surface that is of the metal pillar body 30 and that is not in contact with the dielectric layer 10 expands to be in contact with the dielectric layer 10.

S40: As shown in FIG. 11D, remove a chemically processed part of a top surface of the metal pillar body 30 to form a first conductive pillar 31.

For steps S20, S30, and S40, refer to related descriptions in Example 1. Details are not described herein again.

S50: As shown in FIG. 10A, form a second conductive pattern 41 on a side that is of the dielectric layer 10 and that is away from the first conductive pattern 21, where the second conductive pattern 41 is coupled to the first conductive pillar 31.

With improvement of performance and integration of an electronic device, a chip with a single function cannot meet a requirement, and a 3D die gradually becomes a future development trend. However, there is a problem that depth-to-width ratios of the first conductive pillar 31 and the second conductive pillar 32 are large. Therefore, in the chip provided in this embodiment of this application, both the first conductive pillar 31 and the second conductive pillar 32 are directly in contact with the dielectric layer 10 without the film layer such as the barrier layer. In this way, no film layer such as the barrier layer occupies space, and the depth-to-width ratios of the first conductive pillar 31 and the second conductive pillar 32 can be larger, to meet a requirement of the 3D die. In addition, resistance of the first conductive pillar 31 and the second conductive pillar 32 is not affected by the film layer such as the barrier layer, and the resistance of the first conductive pillar 31 and the second conductive pillar 32 can be effectively reduced.

On this basis, the first conductive pillar 31 includes the metal pillar 311 and the metal compound layer 312. A gap defect existing between the formed metal pillar 311 and the dielectric layer 10 due to a process limitation can be filled by using the metal compound layer 312. This can avoid as far as possible damage to the first conductive pattern 21 at the bottom of the first conductive pillar 31 and eventual failure of the chip that are caused by penetration of a solution, for example, an acid lapping liquid, a cleaning fluid, or an etchant, into the gap between the first conductive pillar 31 and the dielectric layer 10.

In addition, because the gap between the metal pillar 311 and the dielectric layer 10 is very small, a volume of the metal compound layer 312 located in the gap is also very small. Therefore, impact of the metal compound layer 312 on the resistance of the first conductive pillar 31 is very small and can be almost ignored, and existence of the metal compound layer 312 does not cause an increase in the resistance of the first conductive pillar 31.

In some embodiments, an embodiment of this application further provides a chip. The chip is a chip obtained by packaging the foregoing 3D die in this example.

### Example 3

An embodiment of this application provides a chip, and the chip is a packaged chip.

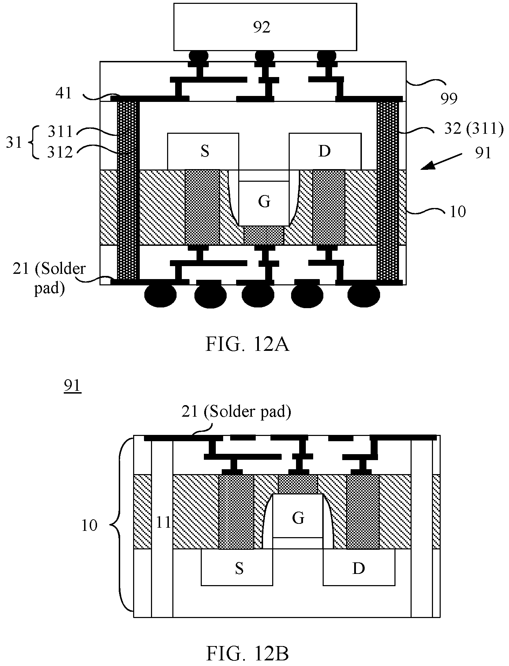

In some embodiments, as shown in FIG. 12A, the chip includes a first die 91, a second die 92, and a fourth redistribution layer 99.

A solder pad of the first die 91 is the first conductive pattern 21, and the first conductive pillar 31 runs through a non-active surface of the first die 91 to a rear surface of the solder pad. The fourth redistribution layer 99 includes the second conductive pattern 41, and the second conductive pattern 41 is coupled to the first conductive pillar 31. The second die 92 is located on a side that is of the fourth redistribution layer 99 and that is far away from the first die 91, and the second die 92 is coupled to the fourth redistribution layer 99. For example, as shown in FIG. 12A, the second die 92 is coupled to the fourth redistribution layer 99 through bonding through a solder ball.

A signal of the first die 91 is transmitted, through the solder pad, to a substrate (not shown in FIG. 12A) bonded with the first die 91. A signal of the second die 92 is transmitted to the fourth redistribution layer 99, is transmitted to the solder pad of the first die 91 through the first conductive pillar 31, and then is transmitted to the substrate bonded with the first die 91.

Structures of the first die 91 and the second die 92 are not limited in this embodiment of this application, and may be properly disposed as needed.

Still refer to FIG. 12A. The first conductive pillar 31 includes a metal pillar 311 and a metal compound layer 312, the metal compound layer 312 is located between the metal pillar 311 and the dielectric layer 10, the metal compound layer 312 covers at least a part of a side surface of the metal pillar 311, and the metal compound layer 312 and a side surface that is of the metal pillar 311 and that is not covered by the metal compound layer 312 are in contact with the dielectric layer 10.

In some embodiments, the chip further includes a second conductive pillar 32, and the second conductive pillar 32 includes the metal pillar 311, and does not include the metal compound layer 312.

Structures of the first conductive pillar 31 and the second conductive pillar 32 may be the same as structures of the first conductive pillar 31 and the second conductive pillar 32 in Example 1. For details, refer to related descriptions in Example 1. Details are not described herein again.

It should be emphasized herein that, in this example, the first conductive pillar 31 and the second conductive pillar 32 run through the non-active surface of the first die 91 to the rear surface of the solder pad. Therefore, as shown in FIG. 12B, the dielectric layer 10 in this example includes a substrate in an integrated circuit module formed in a front end of line, an insulation layer in an contact layerformed in a mid end of line, and a plurality of insulation layers in a redistribution layer formed in a back end of line. A hole 11 in the dielectric layer 10 is located above the solder pad of the first die 91.

The following shows an example of a chip preparation method provided in an embodiment of this application, including:

S10: As shown in FIG. 12B, provide a dielectric layer 10 and a first conductive pattern 21 located on a side of the dielectric layer 10.

In the structure shown in FIG. 12B, for example, a die may be first formed in a front end of line, a mid end of line, and a back end of line, and then the hole 11 is formed by using a hole opening process, to obtain the first die 91 in this application.

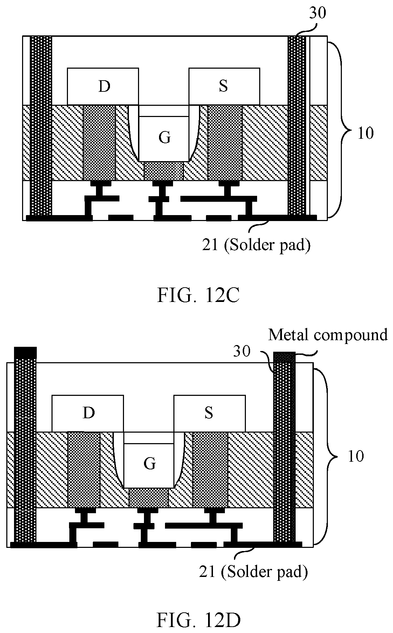

S20: As shown in FIG. 12C, by using a selective deposition process, deposit from a surface of the first conductive pattern 21 in the hole 11, to form a metal pillar body 30 from bottom to top.

S30: As shown in FIG. 12D, perform chemical processing on the metal pillar body 30, so that a side surface that is of the metal pillar body 30 and that is not in contact with the dielectric layer 10 expands to be in contact with the dielectric layer 10.

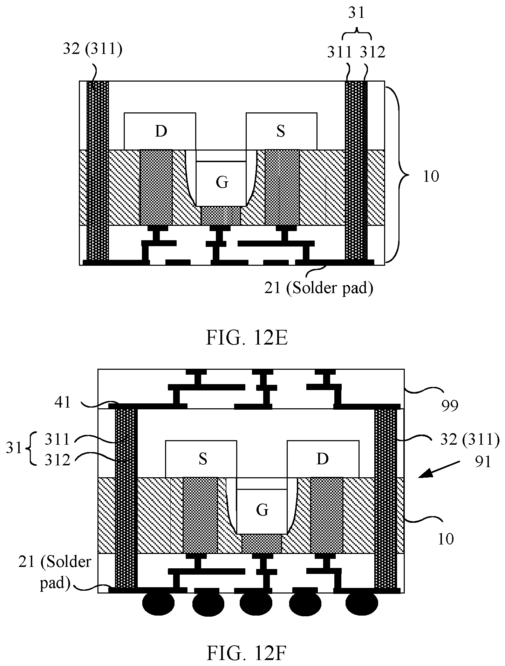

S40: As shown in FIG. 12E, remove a chemically processed part of a top surface of the metal pillar body 30 to form a first conductive pillar 31.

For steps S20, S30, and S40, refer to related descriptions in Example 1. Details are not described herein again.

S50: As shown in FIG. 12F, form a second conductive pattern 41 on a side that is of the dielectric layer 10 and that is away from the first conductive pattern 21, where the second conductive pattern 41 is coupled to the first conductive pillar 31.

For example, a fourth redistribution layer 99 is formed on a side that is of the dielectric layer 10 and that is away from the first conductive pattern 21, and the fourth redistribution layer 99 includes the second conductive pattern 41.

S60: As shown in FIG. 12A, the second die 92 is coupled to the fourth redistribution layer 99 through bonding.

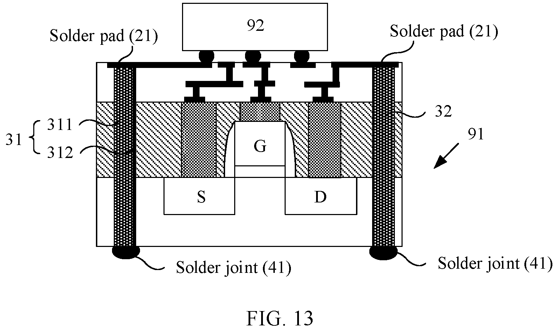

In some other embodiments, as shown in FIG. 13, the chip includes a first die 91, a second die 92, and a solder joint.

A solder pad of the first die 91 is the first conductive pattern 21, and the first conductive pillar 31 runs through a non-active surface of the first die 91 to a rear surface of the solder pad. The solder joint is the second conductive pattern 41, and the second conductive pattern 41 is coupled to the first conductive pillar 31.

A signal of the first die 91 is transmitted to the first conductive pillar 31 through the solder pad, then transmitted to the solder joint (the second conductive pattern 41), and then transmitted to a substrate (not shown in FIG. 13) bonded with the first die 91.

Still refer to FIG. 13. The first conductive pillar 31 includes a metal pillar 311 and a metal compound layer 312, the metal compound layer 312 is located between the metal pillar 311 and the dielectric layer 10, the metal compound layer 312 covers at least a part of a side surface of the metal pillar 311, and the metal compound layer 312 and a side surface that is of the metal pillar 311 and that is not covered by the metal compound layer 312 are in contact with the dielectric layer 10.

In some embodiments, the chip further includes a second conductive pillar 32, and the second conductive pillar 32 includes the metal pillar 311, and does not include the metal compound layer 312. Two ends of the second conductive pillar 32 are respectively coupled to the solder pad of the first die 91 and the solder joint (the second conductive pattern 41) of the non-active surface of the first die 91.

Structures of the first conductive pillar 31 and the second conductive pillar 32 may be the same as structures of the first conductive pillar 31 and the second conductive pillar 32 in Example 1. For details, refer to related descriptions in Example 1. Details are not described herein again.

It should be emphasized herein that, in this example, the first conductive pillar 31 and the second conductive pillar 32 run through the non-active surface of the first die 91 to the rear surface of the solder pad. Therefore, as shown in FIG. 12B, the dielectric layer 10 in this example includes a substrate in an integrated circuit module formed in a front end of line, an insulation layer in an contact layerformed in a mid end of line, and a plurality of insulation layers in a redistribution layer formed in a back end of line. A hole 11 in the dielectric layer 10 is located above the solder pad of the first die 91.

The following shows an example of a chip preparation method provided in an embodiment of this application, including:
S10 to S40 are the same as the chip preparation method when the chip includes the fourth redistribution layer 99 in this example, and details are not described herein again.

S50: As shown in FIG. 12F, form a second conductive pattern 41 on a side that is of the dielectric layer 10 and that is away from the first conductive pattern 21, where the second conductive pattern 41 is coupled to the first conductive pillar 31.

For example, the second conductive pattern 41 is a solder joint located on the non-active surface of the first die 91. For example, the second conductive pattern 41 is a structure such as a solder ball or a micro bump.

S60: Couple the second die 92 with the solder pad of the first die 91 through bonding.

Step S60 may alternatively be performed before step S10 or after another step. This is not limited in this embodiment of this application to that step S60 is performed after S50.

With improvement of performance and integration of an electronic device, a chip with a single function cannot meet a requirement, and a 3D stacked package chip gradually becomes a future development trend. However, there is a problem that depth-to-width ratios of the first conductive pillar 31 and the second conductive pillar 32 are large. Therefore, the chip provided in this embodiment of this application is based on structures and a preparation method of the first conductive pillar 31 and the second conductive pillar 32, which can be applied to a chip having a high requirement on the depth-to-width ratio.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip, comprising:
a first conductive pillar and a dielectric layer, wherein the first conductive pillar is disposed in the dielectric layer, and runs through the dielectric layer in a thickness direction of the dielectric layer; and
a first conductive pattern and a second conductive pattern, located on two opposite sides of the first conductive pillar, wherein the first conductive pillar is correspondingly coupled to the first conductive pattern and the second conductive pattern,
**characterised in that** :
the first conductive pillar comprises a metal pillar and a metal compound layer, the metal compound layer is located between the metal pillar and the dielectric layer and covers at least a part of a side surface of the metal pillar, the metal compound layer is in contact with the dielectric layer, and a side surface that is of the metal pillar and that is not covered by the metal compound layer is also in contact with the dielectric layer.

2. The chip according to claim 1, wherein the metal pillar is formed by using a selective deposition process.

3. The chip according to claim 1 or 2, wherein the metal compound layer comprises at least one of a metal oxide material, a metal nitride material, or a metal oxynitride material.

4. The chip according to claim 1 or 2, wherein the metal compound layer is obtained by performing oxidation treatment and/or nitride treatment on the side surface of the metal pillar.

5. The chip according to any one of claims 1 to 4, wherein the metal compound layer has a width of 0.5 nm to 5 nm in a direction parallel to the dielectric layer.

6. The chip according to any one of claims 1 to 5, wherein a material of the first conductive pattern comprises metal, and the first conductive pillar is in contact with the first conductive pattern.

7. The chip according to any one of claims 1 to 6, wherein the chip comprises an electronic component and a first redistribution layer, the first conductive pattern is disposed between the first conductive pillar and the electronic component, and the first redistribution layer comprises the second conductive pattern.

8. The chip according to any one of claims 1 to 6, wherein the chip comprises a first integrated circuit module, a second redistribution layer, a second integrated circuit module, and a third redistribution layer that are sequentially stacked; and
the second redistribution layer comprises the first conductive pattern, the first conductive pattern is coupled to the first integrated circuit module, the first conductive pillar runs through the second integrated circuit module, the third redistribution layer comprises the second conductive pattern, and the third redistribution layer is further coupled to the second integrated circuit module.

9. The chip according to any one of claims 1 to 6, wherein the chip comprises a die;
a solder pad of the die is the first conductive pattern, and the first conductive pillar runs through a non-active surface of the die to a rear surface of the solder pad; and
the chip further comprises a fourth redistribution layer, and the fourth redistribution layer comprises the second conductive pattern.

10. The chip according to any one of claims 1 to 6, wherein the chip comprises a die;
a solder pad of the die is the first conductive pattern, and the first conductive pillar runs through a non-active surface of the die to a rear surface of the solder pad; and
the second conductive pattern is a solder joint located on the non-active surface of the die.

11. The chip according to any one of claims 1 to 10, wherein the chip comprises a plurality of first conductive pillars, and oxygen content, nitrogen content, or widths of a plurality of metal compound layers comprised in the plurality of first conductive pillars are not completely the same.

12. The chip according to any one of claims 1 to 11, wherein the chip further comprises a second conductive pillar, the second conductive pillar is the metal pillar, the metal pillar is disposed in the dielectric layer and runs through the dielectric layer in the thickness direction of the dielectric layer, and a side surface of the metal pillar is in contact with the dielectric layer.

13. An electronic device, comprising the chip according to any one of claims 1 to 12 and a circuit board, wherein the chip is disposed on the circuit board.

14. A chip preparation method, comprising:
providing a dielectric layer and a first conductive pattern located on a first intermediate dielectric layer side, wherein the dielectric layer has a hole, and the hole is located above the first conductive pattern;
by using a selective deposition process, depositing from a surface of the first conductive pattern in the hole, to form a metal pillar body from bottom to top;
performing chemical processing on the metal pillar body, so that a side surface that is of the metal pillar body and that is not in contact with the dielectric layer expands to be in contact with the dielectric layer;
removing a chemically processed part of a top surface of the metal pillar body to form a first conductive pillar, wherein the first conductive pillar comprises a metal pillar and a metal compound layer, a part that is of the metal pillar body and that is not chemically processed is the metal pillar, a chemically processed part of the side surface of the metal pillar body is the metal compound layer, the metal compound layer is in contact with the dielectric layer, and a side surface that is of the metal pillar and that is not covered by the metal compound layer is also in contact with the dielectric layer; and
forming a second conductive pattern on a side that is of the dielectric layer and that is away from the first conductive pattern, wherein the second conductive pattern is coupled to the first conductive pillar.

15. The chip preparation method according to claim 14, wherein the performing chemical processing on the metal pillar body comprises:
performing oxidation treatment on the metal pillar body; and/or
performing nitride treatment on the metal pillar body.

## Patentansprüche

1. Chip, der Folgendes umfasst:
eine erste leitende Säule und eine dielektrische Schicht, wobei die erste leitende Säule in der dielektrischen Schicht angeordnet ist und durch die dielektrische Schicht in einer Dickenrichtung der dielektrischen Schicht verläuft; und
ein erstes leitendes Muster und ein zweites leitendes Muster, die auf zwei gegenüberliegenden Seiten der ersten leitenden Säule angeordnet sind, wobei die erste leitende Säule an das erste leitende Muster bzw. das zweite leitende Muster gekoppelt ist,
**dadurch gekennzeichnet, dass**
die erste leitende Säule eine Metallsäule und eine Metallverbundschicht umfasst, die Metallverbundschicht zwischen der Metallsäule und der dielektrischen Schicht angeordnet ist und mindestens einen Abschnitt einer Seitenoberfläche der Metallsäule abdeckt, die Metallverbundschicht mit der dielektrischen Schicht in Kontakt ist, und eine Seitenoberfläche, die von der Metallsäule stammt und die durch die Metallverbundschicht nicht abgedeckt ist, auch mit der dielektrischen Schicht in Kontakt ist.

2. Chip nach Anspruch 1, wobei die Metallsäule unter Verwendung eines selektiven Abscheidungsprozesses gebildet ist.

3. Chip nach Anspruch 1 oder 2, wobei die Metallverbundschicht mindestens eines eines Metalloxidmaterials, eines Metallnitridmaterials oder eines Metalloxinitridmaterials umfasst.

4. Chip nach Anspruch 1 oder 2, wobei die Metallverbundschicht durch Durchführen einer Oxidationsbehandlung und/oder einer Nitridbehandlung an der Seitenoberfläche der Metallsäule erhalten wird.

5. Chip nach einem der Ansprüche 1 bis 4, wobei die Metallverbundschicht eine Breite im Bereich von 0,5 nm bis 5 nm in einer Richtung parallel zur dielektrischen Schicht aufweist.

6. Chip nach einem der Ansprüche 1 bis 5, wobei ein Material des ersten leitenden Musters Metall enthält und die erste leitende Säule mit dem ersten leitenden Muster in Kontakt ist.

7. Chip nach einem der Ansprüche 1 bis 6, wobei der Chip ein elektronisches Bauteil und eine erste Umverteilungsschicht umfasst, das erste leitende Muster zwischen der ersten leitenden Säule und dem elektronischen Bauteil angeordnet ist und die erste Umverteilungsschicht das zweite leitende Muster umfasst.

8. Chip nach einem der Ansprüche 1 bis 6, wobei der Chip ein erstes integriertes Schaltungsmodul, eine zweite Umverteilungsschicht, ein zweites integriertes Schaltungsmodul und eine dritte Umverteilungsschicht umfasst, die sequenziell gestapelt sind; und
die zweite Umverteilungsschicht das erste leitende Muster umfasst, das erste leitende Muster an das erste integrierte Schaltungsmodul gekoppelt ist, die erste leitende Säule durch das zweite integrierte Schaltungsmodul verläuft, die dritte Umverteilungsschicht das zweite leitende Muster umfasst und die dritte Umverteilungsschicht ferner an das zweite integrierte Schaltungsmodul gekoppelt ist.

9. Chip nach einem der Ansprüche 1 bis 6, wobei der Chip eine Matrize umfasst;
eine Lötanschlussfläche der Matrize das erste leitende Muster ist und die erste leitende Säule durch eine nicht aktive Oberfläche der Matrize zu einer Rückoberfläche der Lötanschlussfläche verläuft; und
der Chip ferner eine vierte Umverteilungsschicht umfasst und die vierte Umverteilungsschicht das zweite leitende Muster umfasst.

10. Chip nach einem der Ansprüche 1 bis 6, wobei der Chip eine Matrize umfasst;
eine Lötanschlussfläche der Matrize das erste leitende Muster ist und die erste leitende Säule durch eine nicht aktive Oberfläche der Matrize zu einer Rückoberfläche der Lötanschlussfläche verläuft; und
das zweite leitende Muster ein Lötverbinder ist, der an der nicht aktiven Oberfläche der Matrize angeordnet ist.

11. Chip nach einem der Ansprüche 1 bis 10, wobei der Chip mehrere erste leitende Säulen umfasst und der Sauerstoffgehalt, der Stickstoffgehalt oder Breiten von mehreren Metallverbundschichten, die in den mehreren ersten leitenden Säulen enthalten sind, nicht vollständig gleich sind.

12. Chip nach einem der Ansprüche 1 bis 11, wobei der Chip ferner eine zweite leitende Säule umfasst, die zweite leitende Säule die Metallsäule ist, die Metallsäule in der dielektrischen Schicht angeordnet ist und durch die dielektrische Schicht in der Dickenrichtung der dielektrischen Schicht verläuft und eine Seitenoberfläche der Metallsäule mit der dielektrischen Schicht in Kontakt ist.

13. Elektronische Vorrichtung, die den Chip nach einem der Ansprüche 1 bis 12 und eine Leiterplatte umfasst, wobei der Chip an der Leiterplatte angeordnet ist.

14. Chipanfertigungsverfahren, das Folgendes umfasst:
Bereitstellen einer dielektrischen Schicht und eines ersten leitenden Musters, das an einer ersten zwischenliegenden Seite der dielektrischen Schicht angeordnet ist, wobei die dielektrische Schicht ein Loch aufweist und das Loch über dem ersten leitenden Muster angeordnet ist;
Abscheiden unter Verwendung eines selektiven Abscheidungsprozesses von einer Oberfläche des ersten leitenden Musters in das Loch, um einen Metallsäulenkörper von unten nach oben zu bilden;
Durchführen einer chemischen Verarbeitung am Metallsäulenkörper, derart, dass eine Seitenoberfläche, die vom Metallsäulenkörper stammt und die mit der dielektrischen Schicht nicht in Kontakt ist, sich ausdehnt, um mit der dielektrischen Schicht in Kontakt zu sein;
Entfernen eines chemisch verarbeiteten Abschnitts einer oberen Oberfläche des Metallsäulenkörpers, um eine erste leitende Säule zu bilden, wobei die erste leitende Säule eine Metallsäule und eine Metallverbundschicht umfasst, ein Abschnitt, der vom Metallsäulenkörper stammt und der nicht chemisch verarbeitet ist, die Metallsäule ist, ein chemisch verarbeiteter Abschnitt der Seitenoberfläche des Metallsäulenkörpers die Metallverbundschicht ist, die Metallverbundschicht mit der dielektrischen Schicht in Kontakt ist und eine Seitenoberfläche, die von der Metallsäule stammt und die durch die Metallverbundschicht nicht abgedeckt ist, auch mit der dielektrischen Schicht in Kontakt ist; und
Bilden eines zweiten leitenden Musters auf einer Seite, die von der dielektrischen Schicht stammt und die vom ersten leitenden Muster abgewandt ist, wobei das zweite leitende Muster an die erste leitende Säule gekoppelt ist.

15. Chipanfertigungsverfahren nach Anspruch 14, wobei das Durchführen der chemischen Verarbeitung am Metallsäulenkörper Folgendes umfasst:
Durchführen einer Oxidationsbehandlung am Metallsäulenkörper und/oder
Durchführen einer Nitridbehandlung am Metallsäulenkörper.

## Revendications

1. Puce, comprenant :
un premier pilier conducteur et une couche diélectrique, le premier pilier conducteur étant disposé dans la couche diélectrique, et traversant la couche diélectrique dans une direction d'épaisseur de la couche diélectrique ; et
un premier motif conducteur et un deuxième motif conducteur, situés sur deux côtés opposés du premier pilier conducteur, le premier pilier conducteur étant couplé respectivement au premier motif conducteur et au deuxième motif conducteur,
**caractérisée en ce que** :
le premier pilier conducteur comprend un pilier métallique et une couche de composé métallique, la couche de composé métallique est située entre le pilier métallique et la couche diélectrique et recouvre au moins une partie d'une surface latérale du pilier métallique, la couche de composé métallique est en contact avec la couche diélectrique, et une surface latérale qui est du pilier métallique et qui n'est pas recouverte par la couche de composé métallique est également en contact avec la couche diélectrique.

2. Puce selon la revendication 1, dans laquelle le pilier métallique est formé à l'aide d'un procédé de dépôt sélectif.

3. Puce selon la revendication 1 ou 2, dans laquelle la couche de composé métallique comprend au moins un matériau parmi un matériau d'oxyde métallique, un matériau de nitrure métallique, ou un matériau d'oxynitrure métallique.

4. Puce selon la revendication 1 ou 2, dans laquelle la couche de composé métallique est obtenue par réalisation d'un traitement d'oxydation et/ou un traitement de nitruration sur la surface latérale du pilier métallique.

5. Puce selon l'une quelconque des revendications 1 à 4, dans laquelle la couche de composé métallique présente une largeur de 0,5 nm à 5 nm dans une direction parallèle à la couche diélectrique.

6. Puce selon l'une quelconque des revendications 1 à 5, dans laquelle un matériau du premier motif conducteur comprend un métal, et le premier pilier conducteur est en contact avec le premier motif conducteur.

7. Puce selon l'une quelconque des revendications 1 à 6, la puce comprenant un composant électronique et une première couche de redistribution, le premier motif conducteur est disposé entre le premier pilier conducteur et le composant électronique, et la première couche de redistribution comprend le deuxième motif conducteur.

8. Puce selon l'une quelconque des revendications 1 à 6, la puce comprenant un premier module de circuit intégré, une deuxième couche de redistribution, un deuxième module de circuit intégré, et une troisième couche de redistribution empilés successivement ; et
la deuxième couche de redistribution comprenant le premier motif conducteur, le premier motif conducteur étant couplé au premier module de circuit intégré, le premier pilier conducteur traversant le deuxième module de circuit intégré, la troisième couche de redistribution comprenant le deuxième motif conducteur, et la troisième couche de redistribution étant en outre couplée au deuxième module de circuit intégré.

9. Puce selon l'une quelconque des revendications 1 à 6, la puce comprenant un die ;
un plot de soudure du die étant le premier motif conducteur, et le premier pilier conducteur traversant une surface non active du die jusqu'à une surface arrière du plot de soudure ; et
la puce comprenant en outre une quatrième couche de redistribution, et la quatrième couche de redistribution comprenant le deuxième motif conducteur.

10. Puce selon l'une quelconque des revendications 1 à 6, la puce comprenant un die ;
un plot de soudure du die étant le premier motif conducteur, et le premier pilier conducteur traversant une surface non active du die jusqu'à une surface arrière du plot de soudure ; et
le deuxième motif conducteur constituant un joint de soudure situé sur la surface non active du die.

11. Puce selon l'une quelconque des revendications 1 à 10, la puce comprenant une pluralité de premiers piliers conducteurs, et une teneur en oxygène, une teneur en azote, ou des largeurs d'une pluralité de couches de composé métallique comprises dans la pluralité de premiers piliers conducteurs n'étant pas strictement identiques.

12. Puce selon l'une quelconque des revendications 1 à 11, la puce comprenant en outre un deuxième pilier conducteur, le deuxième pilier conducteur étant le pilier métallique, le pilier métallique étant disposé dans la couche diélectrique et traversant la couche diélectrique selon la direction d'épaisseur de la couche diélectrique, et une surface latérale du pilier métallique étant en contact avec la couche diélectrique.

13. Dispositif électronique, comprenant la puce selon l'une quelconque des revendications 1 à 12 et une carte de circuit imprimé, la puce étant disposée sur la carte de circuit imprimé.

14. Procédé de préparation d'une puce, comprenant :
la fourniture d'une couche diélectrique et d'un premier motif conducteur situé sur un côté d'une première couche diélectrique intermédiaire, la couche diélectrique étant pourvue d'un trou, et le trou étant situé au-dessus du premier motif conducteur ;
la réalisation d'un dépôt, à l'aide d'un procédé de dépôt sélectif, à partir d'une surface du premier motif conducteur dans le trou, afin de former un corps de pilier métallique de bas en haut ;
la réalisation d'un traitement chimique sur le corps de pilier métallique, de sorte qu'une surface latérale du corps de pilier métallique qui n'est pas en contact avec la couche diélectrique se dilate pour entrer en contact avec la couche diélectrique ;
l'élimination d'une partie chimiquement traitée d'une surface supérieure du corps de pilier métallique afin de former un premier pilier conducteur, le premier pilier conducteur comprenant un pilier métallique et une couche de composé métallique, une partie du corps de pilier métallique qui n'est pas chimiquement traitée constituant le pilier métallique, une partie chimiquement traitée de la surface latérale du corps de pilier métallique constituant la couche de composé métallique, la couche de composé métallique étant en contact avec la couche diélectrique, et une surface latérale du pilier métallique qui n'est pas recouverte par la couche de composé métallique étant également en contact avec la couche diélectrique ; et
la formation d'un deuxième motif conducteur sur un côté de la couche diélectrique qui est éloigné du premier motif conducteur, le deuxième motif conducteur étant couplé au premier pilier conducteur.

15. Procédé de préparation d'une puce selon la revendication 14, dans lequel la réalisation d'un traitement chimique sur le corps de pilier métallique comprend :
la réalisation d'un traitement d'oxydation sur le corps de pilier métallique ; et/ou
la réalisation d'un traitement de nitruration sur le corps de pilier métallique.
